# EUROPEAN PATENT SPECIFICATION

(11) **EP 4 451 654 B1**
(45) Date of publication and mention of the grant of the patent: **11.03.2026**
(21) Application number: 23752997.9
(22) Date of filing: 04.01.2023
(51) Int. Cl.: H04M 1/02, H05K 1/14, H05K 5/00, H04M 1/18, H05K 1/02, H05K 1/18

(54) **ELECTRONIC DEVICE COMPRISING BUFFER STRUCTURE**
ELEKTRONISCHE VORRICHTUNG MIT PUFFERSTRUKTUR
DISPOSITIF ÉLECTRONIQUE COMPRENANT UNE STRUCTURE TAMPON

(30) Priority: 08.02.2022 KR 20220016086; 08.04.2022 KR 20220044009
(43) Date of publication of application: 23.10.2024
(73) Proprietor: Samsung Electronics Co., Ltd., Suwon-si, Gyeonggi-do 16677 (KR)
(72) Inventor: PARK, Jaeyong, Suwon-si Gyeonggi-do 16677 (KR); SHIN, Kwangha, Suwon-si Gyeonggi-do 16677 (KR)
(74) Representative: HGF
(86) International application number: PCT/KR2023/000128
(87) International publication number: WO 2023/153645

(56) References cited:
- JP-A- 2001 266 977
- JP-A- 2012 064 985
- JP-A- H05 242 920
- KR-A- 20140 067 811
- KR-A- 20210 149 493
- US-A1- 2018 198 089

## Description

### TECHNICAL FIELD

The present disclosure relates to an electronic device including a shock absorber and, more particularly, to an electronic device including a shock absorber that buffers an impact applied to a flexible printed circuit board (FPCB).

### BACKGROUND ART

A flexible printed circuit board (FPCB) may be used to connect a plurality of electronic components. For example, the FPCB may be configured to connect a connector of one printed circuit board (PCB) and a connector of another PCB. The above description is information the inventor(s) acquired during the course of conceiving the present disclosure, or already possessed at the time, and is not necessarily art publicly known before the present application was filed.

US 2018/198089 A1 discloses a display device including a display device, a window, and an adhesive material. The display panel includes a display area and a non-display area. The window is on the display panel. The adhesive material is between the display panel and the window. The window includes a base substrate and a blocking barrier. The base substrate includes a first area overlapping the display area, a second area overlapping the non-display area, and a third area protruding outwardly from the display panel. The blocking barrier is on the second area of the base substrate, includes convex patterns and an inner surface facing a central portion of the base substrate. The inner surface of the blocking barrier and the convex patterns contact the adhesive material.

KR 2021 0149493 A discloses an electronic device including: a first printed circuit board having a first surface and a second surface opposite to the first surface; a second printed circuit board having a first surface and a second surface opposite to the first surface and spaced apart from the first printed circuit board; a battery disposed between the first printed circuit board and the second printed circuit board; a first connection member connected to the first surface of the first printed circuit board and connected to one of the first surface and the second surface of the second printed circuit board to electrically connect the first printed circuit board and the second printed circuit board; and a second connection member connected to the second surface of the first printed circuit board and connected to one of the first surface and the second surface of the second printed circuit board to electrically connect the first printed circuit board and the second printed circuit board, wherein the first connection member and the second connection member may be arranged to at least partially overlap at a portion passing the battery.

### DISCLOSURE OF INVENTION

### SOLUTION TO PROBLEM

The invention is defined in the appended claims.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a block diagram illustrating an electronic device in a network environment according to an embodiment;
FIG. 2A is a perspective view of an electronic device viewed in one direction according to an embodiment;
FIG. 2B is a perspective view of an electronic device viewed in another direction according to an embodiment;
FIG. 2C is an exploded perspective view of an electronic device according to an embodiment;
FIG. 3A is a perspective view of an internal structure of an electronic device according to an embodiment;
FIG. 3B is an exploded perspective view of an electronic device according to an embodiment;
FIG. 3C is a perspective view of a housing according to an embodiment;
FIG. 3D is a top plan view of a shock absorber according to an embodiment;
FIG. 3E is a perspective view of a shock absorber according to an embodiment;
FIG. 3F is a schematic cross-sectional view of a shock absorber according to an embodiment;
FIG. 4A is a side view of an electronic device according to an embodiment;
FIG. 4B is a schematic cross-sectional view of a shock absorber according to an embodiment;
FIG. 5A is a perspective view of an internal structure of an electronic device without a shock absorber according to an embodiment;
FIG. 5B is a perspective view of an internal structure of an electronic device with a shock absorber applied according to an embodiment;
FIG. 5C is a schematic cross-sectional view of an electronic device with a shock absorber applied according to an embodiment;
FIG. 6A is a perspective view of an internal structure of an electronic device without a shock absorber according to an embodiment;
FIG. 6B is a perspective view of an internal structure of an electronic device with a shock absorber applied according to an embodiment;
FIG. 6C is a schematic cross-sectional view of an electronic device with a shock absorber applied according to an embodiment;
FIG. 7A is a perspective view of an electronic device including a shock absorber according to an embodiment;
FIG. 7B is a perspective view of an electronic device including a shock absorber according to an embodiment;
FIG. 8 is a perspective view of a shock absorber according to an embodiment;
FIG. 9A is a diagram illustrating an electronic device in an unfolded state according to an embodiment;
FIG. 9B is a diagram illustrating an electronic device in a folded state according to an embodiment;
FIG. 10 is an exploded perspective view of an electronic device according to an embodiment;
FIG. 11A is a diagram schematically illustrating an electronic device in an unfolded state according to an embodiment; and
FIG. 11B is a diagram schematically illustrating an electronic device in a folded state according to an embodiment.

### DETAILED DESCRIPTION

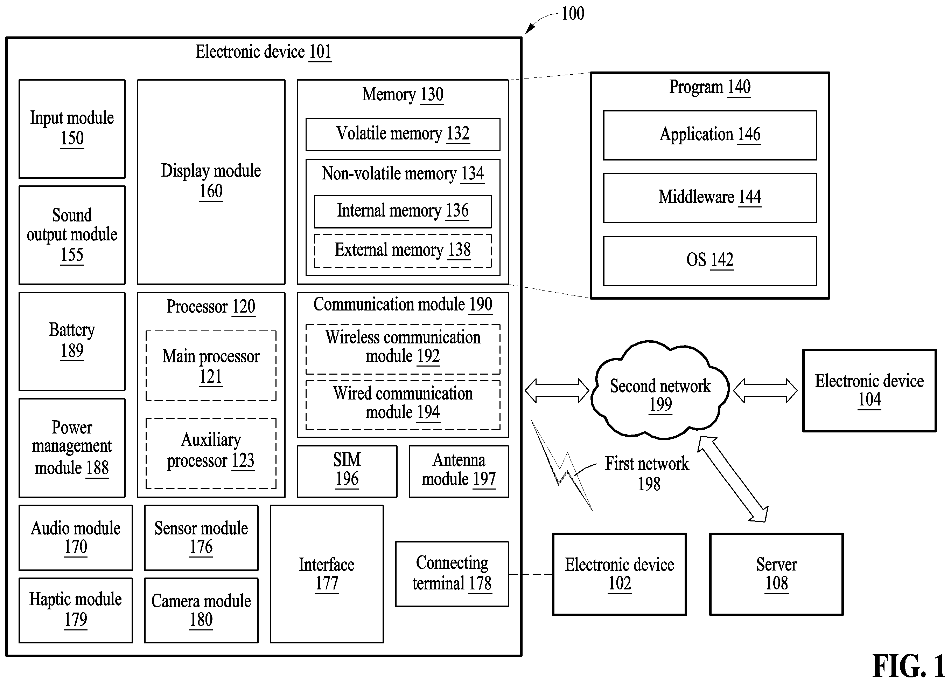

FIG. 1 is a block diagram illustrating an electronic device in a network environment according to an embodiment.

Referring to FIG. 1, an electronic device 101 in a network environment 100 may communicate with an electronic device 102 via a first network 198 (e.g., a short-range wireless communication network), or communicate with at least one of an electronic device 104 and a server 108 via a second network 199 (e.g., a long-range wireless communication network). The electronic device 101 may communicate with the electronic device 104 via the server 108. The electronic device 101 may include a processor 120, a memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added to the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a part of data processing or computation, the processor 120 may store a command or data received from another component (e.g., the sensor module 176 or the communication module 190) in a volatile memory 132, process the command or data stored in the volatile memory 132, and store resulting data in a non-volatile memory 134. The processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) which is operable independently from or in conjunction with, the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). The auxiliary processor 123 (e.g., an ISP or a CP) may be implemented as a portion of another component (e.g., the camera module 180 or the communication module 190) which is functionally related to the auxiliary processor 123. The auxiliary processor 123 (e.g., an NPU) may include a hardware structure specifically for artificial intelligence (AI) model processing. An AI model may be generated by machine learning. The learning may be performed by, for example, the electronic device 101, in which the AI model is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may alternatively or additionally include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. The receiver may be implemented separately from the speaker or as a part of the speaker.

The display module 160 may visually provide information to the outside (e.g., a user) of the electronic device 101. The display module 160 may include, for example, a display, a hologram device, or a projector, and a control circuitry to control its corresponding one of the displays, the hologram device, and the projector. The display module 160 may include a touch sensor adapted to sense a touch, or a pressure sensor adapted to measure an intensity of a force of the touch.

The audio module 170 may convert sound into an electric signal or vice versa. The audio module 170 may obtain the sound via the input module 150 or output the sound via the sound output module 155 or an external electronic device (e.g., the electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with an external electronic device (e.g., the electronic device 102) directly (e.g., by wire) or wirelessly. The interface 177 may include, for example, a high-definition multimedia interface (HDMI), a universal serial bus (USB) interface, a secure digital (SD) card interface, or an audio interface.

The connecting terminal 178 may include a connector via which the electronic device 101 may physically connect to an external electronic device (e.g., the electronic device 102). The connecting terminal 178 may include, for example, an HDMI connector, a USB connector, an SD card connector, or an audio connector (e.g., a headphones connector).

The haptic module 179 may convert an electric signal into a mechanical stimulus (e.g., a vibration or a movement) or an electrical stimulus, which may be recognized by a user via their tactile sensation or kinesthetic sensation. The haptic module 179 may include, for example, a motor, a piezoelectric element, or an electric stimulator.

The camera module 180 may capture a still image and moving images. The camera module 180 may include one or more lenses, image sensors, ISPs, and flashes.

The power management module 188 may manage power supplied to the electronic device 101. The power management module 188 may be implemented as, for example, at least a part of a power management integrated circuit (PMIC).

The battery 189 may supply power to at least one component of the electronic device 101. The battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and an external electronic device (e.g., the electronic device 102, the electronic device 104, or the server 108) and performing communication via the established communication channel. The communication module 190 may include one or more CPs which are operable independently from the processor 120 (e.g., an AP) and which support direct (e.g., wired) communication or wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device, for example, the electronic device 104, via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5^{th} generation (5G) network, a next-generation communication network, the Internet, or a computer network (e.g., an LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4^{th} generation (4G) network, and a next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., an mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beamforming, or a large-scale antenna. The wireless communication module 192 may support various requirements specified in the electronic device 101, an external electronic device (e.g., the electronic device 104), or a network system (e.g., the second network 199). The wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to various embodiments, the antenna module 197 may form an mmWave antenna module. The mmWave antenna module may include a PCB, an RFIC on a first surface (e.g., a bottom surface) of the PCB or adjacent to the first surface of the PCB and capable of supporting a designated high-frequency band (e.g., a mmWave band), and a plurality of antennas (e.g., an antenna array) disposed on a second surface (e.g., a top or a side surface) of the PCB, or adjacent to the second surface of the PCB and capable of transmitting or receiving signals in the designated high-frequency band.

At least some of the above-described components may be coupled mutually and exchange signals (e.g., commands or data) therebetween via an inter-peripheral communication scheme (e.g., a bus, general-purpose input and output (GPIO), serial peripheral interface (SPI), or mobile industry processor interface (MIPI)).

According to an embodiment, commands or data may be transmitted or received between the electronic device 101 and the external electronic device (e.g., the electronic device 104) via the server 108 coupled with the second network 199. Each of the external electronic devices (e.g., the electronic device 102 or 104) may be a device of the same type as or a different type from the electronic device 101. All or some of operations to be executed by the electronic device 101 may be executed by one or more of the external electronic devices (e.g., the electronic devices 102 and 104 and the server 108). For example, if the electronic device 101 needs to perform a function or a service automatically, or in response to a request from a user or another device, the electronic device 101, instead of, or in addition to, executing the function or service, may request one or more external electronic devices to perform at least a part of the function or service. The one or more external electronic devices receiving the request may perform the at least part of the function or the service requested, or an additional function or an additional service related to the request and may transfer a result of the performance to the electronic device 101. The electronic device 101 may provide the result, with or without further processing of the result, as at least part of a response to the request. To that end, cloud computing, distributed computing, mobile edge computing (MEC), or client-server computing technology may be used, for example. The electronic device 101 may provide ultra-low latency services using, e.g., distributed computing or MEC. According to another embodiment, the external electronic device (e.g., the electronic device 104) may include an Internet-of-things (IoT) device. The server 108 may be an intelligent server using machine learning and/or a neural network. According to an embodiment, the external electronic device (e.g., the electronic device 104) or the server 108 may be included in the second network 199. The electronic device 101 may be applied to intelligent services (e.g., a smart home, a smart city, a smart car, or healthcare) based on 5G communication technology or IoT-related technology.

According to various embodiments described herein, an electronic device may be a device of one of various types. The electronic device may include, as non-limiting examples, a portable communication device (e.g., a smartphone), a computing device, a portable multimedia device, a portable medical device, a camera, a wearable device, or a home appliance. However, the electronic device is not limited to the foregoing examples.

It is to be understood that various embodiments of the disclosure and the terms used therein are not intended to limit the technological features set forth herein to particular embodiments and include various changes, equivalents, or replacements for a corresponding embodiment. **In** connection with the description of the drawings, like reference numerals may be used for similar or related components. It is to be understood that a singular form of a noun corresponding to an item may include one or more of the things unless the relevant context clearly indicates otherwise. As used herein, "A or B," "at least one of A and B," "at least one of A or B," "A, B, or C," "at least one of A, B, and C," and "at least one of A, B, or C," each of which may include any one of the items listed together in the corresponding one of the phrases, or all possible combinations thereof. Terms such as "1st" and "2nd" or "first" and "second" may simply be used to distinguish the component from other components in question, and do not limit the components in other aspects (e.g., importance or order). It is to be understood that if an element (e.g., a first element) is referred to, with or without the term "operatively" or "communicatively," as "coupled with," "coupled to," "connected with," or "connected to" another element (e.g., a second element), it denotes that the element may be coupled with the other element directly (e.g., by wire), wirelessly, or via a third element.

As used in connection with some embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in the form of an application-specific integrated circuit (ASIC).

Various embodiments as set forth herein may be implemented as software (e.g., the program 140) including one or more instructions which are stored in a storage medium (e.g., the internal memory 136 or the external memory 138) which is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply denotes that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method described herein may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

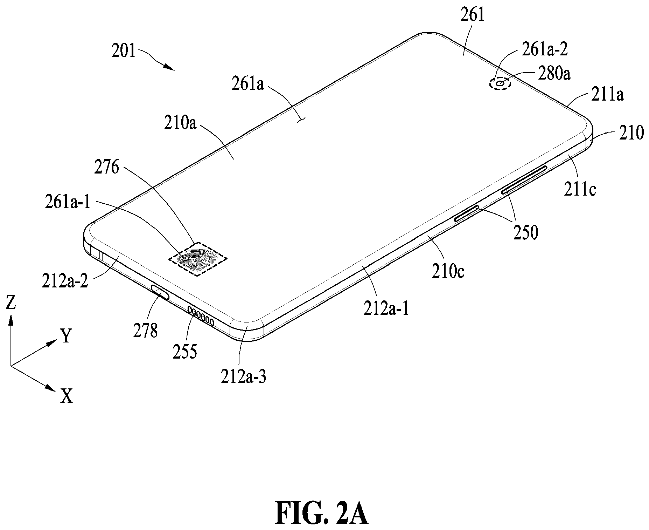

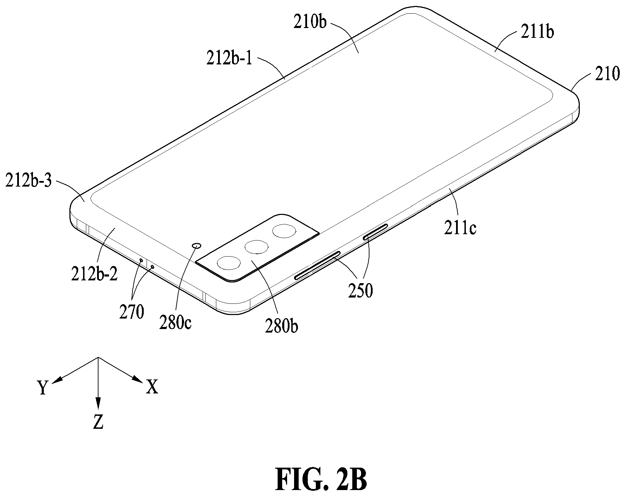

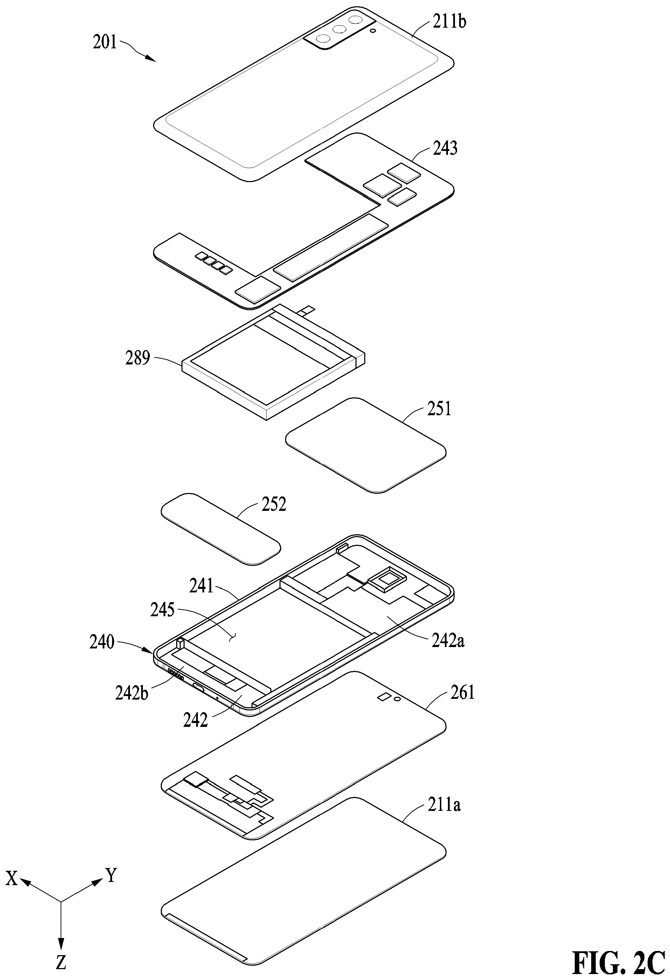

FIG. 2A is a perspective view of an electronic device viewed in one direction according to an embodiment. FIG. 2B is a perspective view of an electronic device viewed in another direction according to an embodiment. FIG. 2C is an exploded perspective view of an electronic device according to an embodiment.

Referring to FIGS. 2A to 2C, an electronic device 201 (e.g., the electronic device 101 in FIG. 1) may include a housing 210 including a first surface 210a (e.g., a front surface), a second surface 210b (e.g., a back surface), and a third surface 210c (e.g., a side surface) surrounding a space defined between the first surface 210a and the second surface 210b.

In an embodiment, the first surface 210a may be formed, at least partially, by a first plate 211a which is substantially transparent. For example, the first plate 211a may include a glass plate or a polymer plate including at least one coating layer. The second surface 210b may be formed by a second plate 211b which is substantially opaque. For example, the second plate 211b may be formed of coated or colored glass, ceramic, polymer, metal (e.g., aluminum, stainless steel (STS), or magnesium), or a combination thereof. The third surface 210c may be formed by a frame 211c which is coupled to the first plate 211a and the second plate 211b and includes metal and/or polymer. The second plate 211b and the frame 211c may be formed seamlessly. The second plate 211b and the frame 211c may be formed of the same material (e.g., aluminum).

**In** an embodiment, the first plate 211a may include a plurality of first edge areas 212a-1. The plurality of first edge areas 212a-1 may face the second plate 211b from at least a portion of the first surface 210a. The plurality of first edge areas 212a-1 may be rounded. The plurality of first edge areas 212a-1 may extend in one direction (e.g., a +/-Y direction). The first plate 211a may include a plurality of second edge areas 212a-2. The plurality of second edge areas 212a-2 may face the second plate 211b from at least a portion of the first surface 210a. The plurality of second edge areas 212a-2 may be rounded. The plurality of second edge areas 212a-2 may extend in the other direction (e.g., a +/-X direction). The first plate 211a may include a plurality of third edge areas 212a-3. The plurality of third edge areas 212a-3 may face the second plate 211b from at least a portion of the first surface 210a. The plurality of third edge areas 212a-3 may be rounded. The plurality of third edge areas 212a-3 may be between the plurality of first edge areas 212a-1 and the plurality of second edge areas 212a-2.

**In** an embodiment, the second plate 211b may include a plurality of fourth edge areas 212b-1. The plurality of fourth edge areas 212b-1 may face the first plate 211a from at least a portion of the second surface 210b. The plurality of fourth edge areas 212b-1 may be rounded. The plurality of fourth edge areas 212b-1 may extend in one direction (e.g., the +/-Y direction). The second plate 211b may include a plurality of fifth edge areas 212b-2. The plurality of fifth edge areas 212b-2 may face the first plate 211a from at least a portion of the second surface 210b. The plurality of fifth edge areas 212b-2 may be rounded. The plurality of fifth edge areas 212b-2 may extend in the other direction (e.g., the +/-X direction). The second plate 211b may include a plurality of sixth edge areas 212b-3. The plurality of sixth edge areas 212b-3 may face the first plate 211a from at least a portion of the second surface 210b. The plurality of sixth edge areas 212b-3 may be rounded. The plurality of sixth edge areas 212b-3 may be between the plurality of fourth edge areas 212b-1 and the plurality of fifth edge areas 212b-2.

In an embodiment, the electronic device 201 may include a display 261 (e.g., the display module 160 in FIG. 1). The display 261 may be disposed on the first surface 210a. The display 261 may be exposed through at least a portion of the first plate 211a (e.g., the plurality of first edge areas 212a-1, the plurality of second edge areas 212a-2, and the plurality of third edge areas 212a-3). The display 261 may have a shape substantially the same as a shape of an outer edge of the first plate 211a. An edge of the display 261 may substantially coincide with the outer edge of the first plate 211a. The display 261 may include a touch detection circuit, a pressure sensor configured to measure the strength (pressure) of touch, and/or a digitizer configured to detect a magnetic field-type stylus pen. The display 261 may include a screen display area 261a which is visually exposed and configured to display content through pixels. The screen display area 261a may include a sensing area 261a-1 and a camera area 261a-2. The sensing area 261a-1 may overlap at least a portion of the screen display area 261a. The sensing area 261a-1 may allow input signals associated with a sensor module 276 (e.g., the sensor module 176 in FIG. 1) to be transmitted therethrough. The sensing area 261a-1 may display content in the same way as the screen display area 261a which does not overlap the sensing area 261a-1. For example, the sensing area 261a-1 may display content while the sensor module 276 is not operating. The camera area 261a-2 may overlap at least a portion of the screen display area 261a. The camera area 261a-2 may allow optical signals associated with a first camera module 280a (e.g., the camera module 180 in FIG. 1) to be transmitted therethrough. The camera area 261a-2 may display content in the same way as the screen display area 261a which does not overlap the camera area 261a-2. For example, the camera area 261a-2 may display content while the first camera module 280a is not operating.

In an embodiment, the electronic device 201 may include an audio module 270 (e.g., the audio module 170 in FIG. 1). The audio module 270 may be disposed on the third surface 210c. The audio module 270 may obtain a sound through at least one hole.

In an embodiment, the electronic device 201 may include the sensor module 276. The sensor module 276 may be disposed on the first surface 210a. The sensor module 276 may form the sensing area 261a-1 in at least a portion of the screen display area 261a. The sensor module 276 may receive an input signal transmitted through the sensing area 261a-1 and generate an electrical signal based on the received input signal. For example, the input signal may have a specified physical quantity (e.g., heat, light, temperature, sound, pressure, ultrasound). For another example, the input signal may include a signal associated with biometric information (e.g., fingerprints) of a user.

In an embodiment, the electronic device 201 may include the first camera module 280a, a second camera module 280b (e.g., the camera module 180), and a flash 280c. The first camera module 280a may be disposed on the first surface 210a. The second camera module 280b and the flash 280c may be disposed on the second surface 210b. At least a portion of the first camera module 280a may be disposed under the display 261. The first camera module 280a may receive an optical signal transmitted through the camera area 261a-2. The second camera module 280b may include a plurality of camera modules (e.g., a dual camera, a triple camera, or a quad camera). The flash 280c may include a light-emitting diode (LED) or a xenon lamp.

In an embodiment, the electronic device 201 may include a sound output module 255 (e.g., the sound output module 155 in FIG. 1). The sound output module 255 may be disposed on the third surface 210c. The sound output module 255 may include one or more holes.

In an embodiment, the electronic device 201 may include an input module 250 (e.g., the input module 150 in FIG. 1). The input module 250 may be disposed on the third surface 210c. The input module 250 may include at least one key input device.

In an embodiment, the electronic device 201 may include a connecting terminal 278 (e.g., the connecting terminal 178). The connecting terminal 278 may be disposed on the third surface 210c. For example, when the electronic device 201 is viewed in one direction (e.g., a +Y direction), the connecting terminal 278 may be positioned at the center of the third surface 210c, and the sound output module 255 may be positioned on one side (e.g., a right side) with respect to the connecting terminal 278.

In an embodiment, the electronic device 201 may include a support 240, a first circuit board 251, a second circuit board 252, and a battery 289 (e.g., the battery 189 in FIG. 1). At least a portion of the support 240 may form the housing 210 together with the first plate 211a and the second plate 211b. The support 240 may include a first frame structure 241, a second frame structure 243, and a plate structure 242. The first frame structure 241 may be formed to surround an edge of the plate structure 242. The first frame structure 241 may connect an edge of the first plate 211a and an edge of the second plate 211b. The first frame structure 241 may surround a space between the first plate 211a and the second plate 211b. The first frame structure 241 may form the third surface 210c of the electronic device 201. The second frame structure 243 may be disposed between the first frame structure 241 and the second plate 211b. The first frame structure 241 and the second frame structure 243 may form at least partially the frame 211c. The plate structure 242 may include a first portion 242a receiving therein the first circuit board 251 and a second portion 242b receiving therein the second circuit board 252. The display 261 may be disposed on one side (e.g., a bottom surface) of the plate structure 242, and the first circuit board 251 and the second circuit board 252 may be disposed on the other side (e.g., a top surface) of the plate structure 242. The plate structure 242 may include an opening 245 disposed between the first portion 242a and the second portion 242b and passing through both sides of the plate structure 242. The opening 245 may receive therein the battery 289.

The embodiments described herein may also be applicable to various types of electronic devices (e.g., a foldable electronic device, a slideable electronic device, a digital camera, a digital video camera, a tablet, a note-type electronic device, and other electronic devices) in addition to the electronic device shown in FIGS. 2A to 2C.

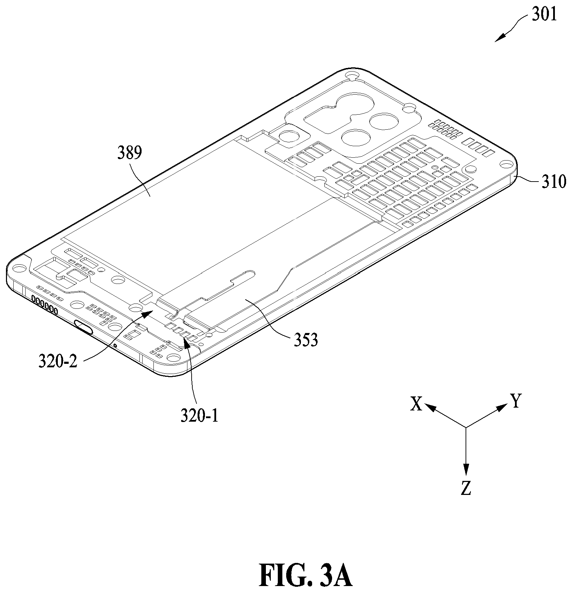

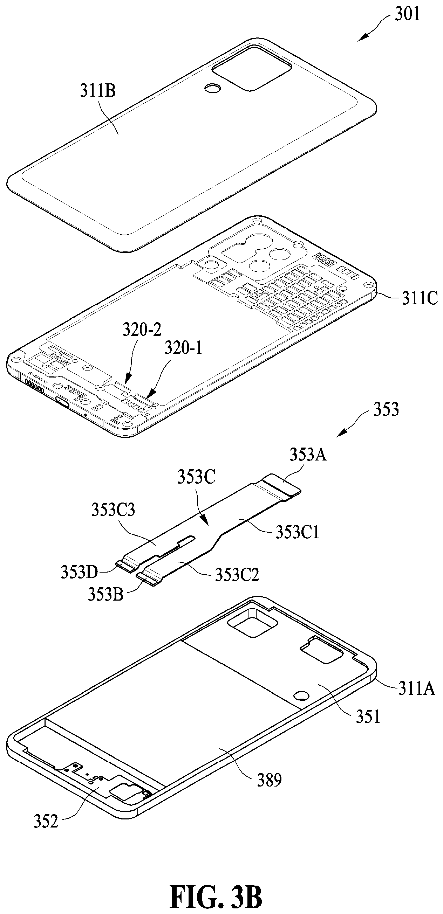

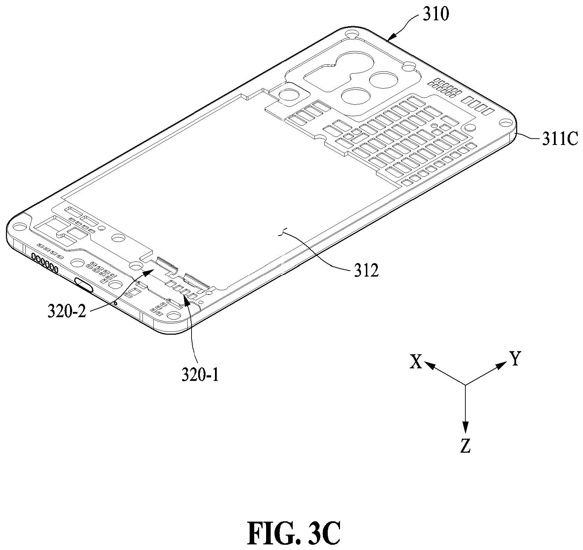

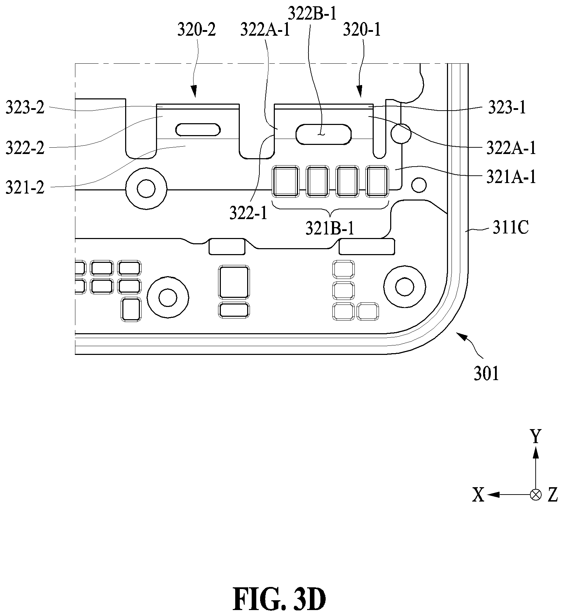

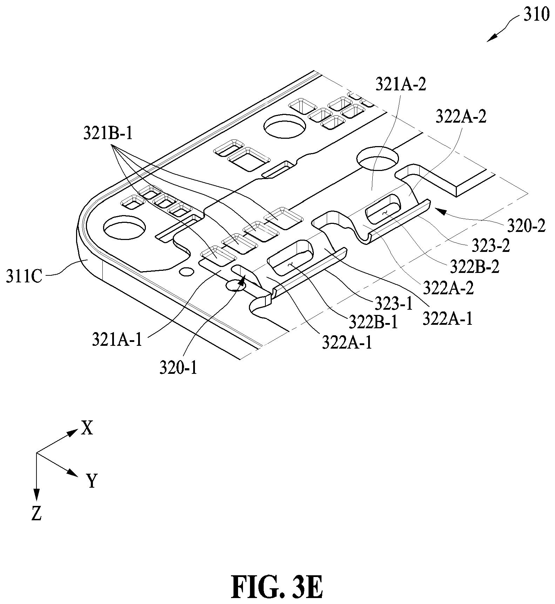

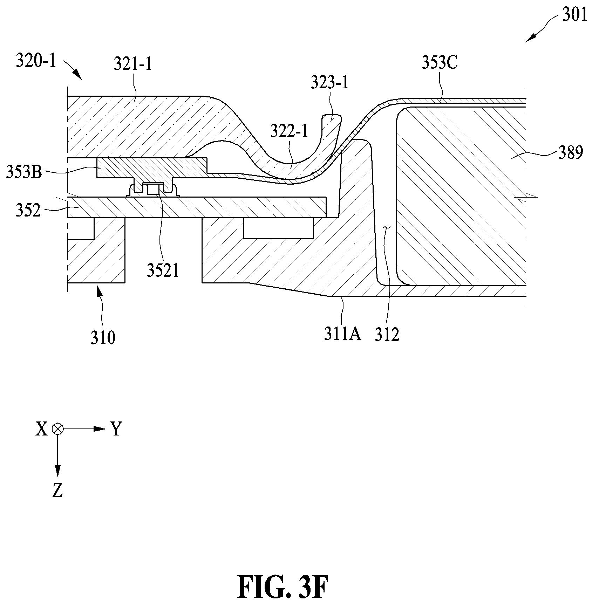

FIG. 3A is a perspective view of an internal structure of an electronic device according to an embodiment. FIG. 3B is an exploded perspective view of an electronic device according to an embodiment. FIG. 3C is a perspective view of a housing according to an embodiment. FIG. 3D is a top view of a shock absorber according to an embodiment. FIG. 3E is a perspective view of a shock absorber according to an embodiment. FIG. 3F is a schematic cross-sectional view of a shock absorber according to an embodiment.

Referring to FIGS. 3A to 3F, an electronic device 301 (e.g., the electronic device 201 in FIGS. 2A to 2C) may include a housing 310 (e.g., the housing 210 in FIGS. 2A to 2C). The housing 310 may include a first plate 311A (e.g., the first frame structure 241 in FIGS. 2A to 2C). The housing 310 may include a second plate 311B (e.g., the second plate 211b in FIGS. 2A to 2C) opposite the first plate 311A. The housing 310 may include a third plate 311C (e.g., the second frame structure 243 in FIGS. 2A to 2C) between the first plate 311A and the second plate 311B.

In an embodiment, the electronic device 301 may include a first PCB 351 (e.g., the first circuit board 251 or a main PCB) disposed in a first portion (e.g., top) of the first plate 311A. The electronic device 301 may include a second PCB 352 (e.g., the second circuit board 252 or a sub-PCB) disposed in a second portion (e.g., bottom) opposite the first portion of the first plate 311A. The electronic device 301 may include a battery 389 disposed in a third portion (e.g., a middle portion) between the first portion and the second portion of the first plate 311A. The electronic device 301 may include a flexible PCB (FPCB) 353 which connects the first PCB 351 and the second PCB 352 to each other and is at least partially disposed on the battery 389.

In an embodiment, the FPCB 353 may include a first connector 353A connected to the first PCB 351. The FPCB 353 may include a second connector 353B connected to the second PCB 352. The FPCB 353 may include an extension portion 353C extending between the first connector 353A and the second connector 353B. The second connector 353B may be configured to be coupled to a connector 3521 (refer to FIG. 3F) on the second PCB 352.

In an embodiment, the FPCB 353 may include a third connector 353D connected to an area of the second PCB 352 which is different from an area to which the second connector 353B is connected.

In an embodiment, the extension portion 353C may include a first extension area 353C1 connected to the first connector 353A. The extension portion 353C may include a second extension area 353C2 separated from the first extension area 353C1 and connected to the second connector 353B. The extension portion 353C may include a third extension area 353C3 separated from the first extension area 353C1 and connected to the third connector 353D. The second extension area 353C2 and the third extension area 353C3 may be disposed separately from each other.

In an embodiment, the third plate 311C may include a receiving portion 312 (e.g., the opening 245) configured to at least partially receive therein the battery 389. For example, the receiving portion 312 may be open to both sides of the third plate 311C.

In an embodiment, the electronic device 301 may include shock absorbers 320-1 and 320-2 configured to elastically support the FPCB 353. For example, when the electronic device 301 receives an external disturbance (e.g., vibration or shock) and the electronic device 301 is at least partially deformed, and when at least a portion of the FPCB 353 is pulled toward the first connector 353A, the second connector 353B, and/or the third connector 353D, the shock absorbers 320-1 and 320-2 may elastically support at least a portion (e.g., the extension portion 353C) of the FPCB 353. In this case, stress concentrated in one portion of the FPCB 353 may be distributed to other portions by the shock absorbers 320-1 and 320-2, which may reduce damage to the FPCB 353 (e.g., damage to the first connector 353A, the second connector 353B, and/or the third connector 353D).

In an embodiment, the electronic device 301 may include a plurality of shock absorbers (e.g., two shock absorbers 320-1 and 320-2). For example, of the plurality of shock absorbers 320-1 and 320-2, one shock absorber 320-1 may be configured to buffer the second extension area 353C2 and the other shock absorber 320-2 may be configured to buffer the third extension area 353C3.

In an embodiment, the shock absorbers 320-1 and 320-2 may include covers 321A-1 and 321A-2 configured to cover at least one component within the electronic device 301. For example, the covers 321A-1 and 321A-2 may be configured to cover the second connector 353B or the third connector 353D. The cover 321A may be configured to support the component by covering the component.

In an embodiment not shown, the shock absorbers 320-1 and 320-2 may include a reinforcement structure to increase the stiffness of the cover 321A. For example, the reinforcement structure may include a metal piece positioned on at least one surface of the covers 321A-1 and 321A-2.

In an embodiment not shown, the shock absorbers 320-1 and 320-2 may include an elastic member configured to elastically support at least a portion of the housing 310. For example, the elastic member may be disposed between the covers 321A-1 and 321A-2 and the component (e.g., the second connector 353B or the third connector 353D) covered by the covers 321A-1 and 321A-2.

In an embodiment, the shock absorber 320-1 may include a recess 321B-1 formed on the cover 321A-1. The recess 321B-1 may reduce breakage of another portion (e.g., a deformable portion 322-1) of the shock absorber 320-1 and assist in a function (e.g., elasticity) of this portion. The shock absorber 320-1 may include a plurality (e.g., four) of recesses 321B-1 arranged along the cover 321A-1 in a direction (e.g., a +/-X direction) intersecting a direction (e.g., a +/-Y direction) in which a deformable portion 322-1 is connected.

In an embodiment, the shock absorbers 320-1 and 320-2 may include deformable portions 322-1 and 322-2 configured to be deformed at least partially elastically. For example, when the electronic device 301 is deformed while the deformable portions 322-1 and 322-2 are contacting and supporting at least a portion (e.g., the second extension area 353C2 and/or third extension area 353C3) of the FPCB 353, and the FPCB 353 is then pulled, the deformable portions 322-1 and 322-2 may be deformed at least partially elastically to absorb an impact applied to the FPCB 353. By providing elasticity to the FPCB 353, the deformable portions 322-1 and 322-2 may distribute stress concentrated in the FPCB 353.

In an embodiment, the deformable portions 322-1 and 322-2 may include a plurality (e.g., two) of ribs 322A-1 and 322A-2 extending from the covers 321A-1 and 321A-2 toward the receiving portion 312. The deformable portions 322-1 and 322-2 may include openings 322B-1 and 322B-2 surrounded by the plurality of ribs 322A-1 and 322A-2. The deformable portions 322-1 and 322-2 may include a plurality of openings 322B-1 and 322B-2 surrounded by the plurality of ribs 322A-1 and 322A-2.

In an embodiment, at least a portion of a surface of the plurality of ribs 322A-1 and 322A-2 facing the FPCB 353 may be substantially a curved surface. The surface of the plurality of ribs 322A-1 and 322A-2 facing the FPCB 353 may be substantially a convex surface. The surface of the plurality of ribs 322A-1 and 322A-2 facing the FPCB 353 may be formed as substantially a flat surface.

In an embodiment, at least a portion of the surface of the plurality of ribs 322A-1 and 322A-2 facing the FPCB 353 may have a surface roughness suitable for reducing friction with the FPCB 353.

In an embodiment, the openings 322B-1 and 322B-2 may extend in a direction (e.g., a +/-X direction) intersecting an extending direction (e.g., a +Y direction) of the plurality of ribs 322A-1 and 322A-2. For example, the openings 322B-1 and 322B-2 may include ends having substantially rounded corners, and slots extending therebetween.

In an embodiment, the thickness of the deformable portions 322-1 and 322-2 may be less than the thickness of the covers 321A-1 and 321A-2. The thickness of the deformable portions 322-1 and 322-2 may be substantially the same as the thickness of the covers 321A-1 and 321A-2.

In an embodiment, the strength of the deformable portions 322-1 and 322-2 may be less than the strength of the covers 321A-1 and 321A-2. The strength of the deformable portions 322-1 and 322-2 may be substantially the same as the strength of the covers 321A-1 and 321A-2.

In an embodiment, the shock absorbers 320-1 and 320-2 may include support portions 323-1 and 323-2 configured to support at least a portion (e.g., the second extension area 353C2 and/or the third extension area 353C3) of the FPCB 353. The support portions 323-1 and 323-2 may be connected to the plurality of ribs 322A-1 and 322A-2. The support portions 323-1 and 323-2 may reduce disconnection of the FPCB 353 which may occur due to an impact which may be applied to the FPCB 353.

In an embodiment, the support portions 323-1 and 323-2 may at least partially face the FPCB 353. At least a portion of a surface of the support portions 323-1 and 323-2 facing the FPCB 353 may contact the FPCB 353. The surface of the support portions 323-1 and 323-2 facing the FPCB 353 may be formed at least partially as a curved surface.

In an embodiment, the surface of the support portions 323-1 and 323-2 facing the FPCB 353 may extend at least partially along an extending direction of the FPCB 353. The support portions 323-1 and 323-2 may extend along a side wall of the first plate 311A which defines the receiving portion 312 configured to receive therein the battery 389. An end among ends of the support portions 323-1 and 323-2 which is opposite to an end connected to the deformable portions 322-1 and 322-2 may be positioned substantially flush with or lower than one surface (e.g., a top surface) of the battery 389 within the electronic device 301.

In an embodiment, the shock absorbers 320-1 and 320-2 may be formed on the third plate 311C. The shock absorbers 320-1 and 320-2 may be seamlessly integrally formed with the third plate 311C. The shock absorbers 320-1 and 320-2 may also be connected, bonded, or coupled to the third plate 311C by co-injection. The shock absorbers 320-1 and 320-2 may be formed on the first plate 311A and/or the second plate 311B.

In an embodiment, the shock absorbers 320-1 and 320-2 may be formed at least partially of an elastic material. For example, the shock absorbers 320-1 and 320-2 may be formed of plastic, urethane, rubber, and/or other highly elastic materials.

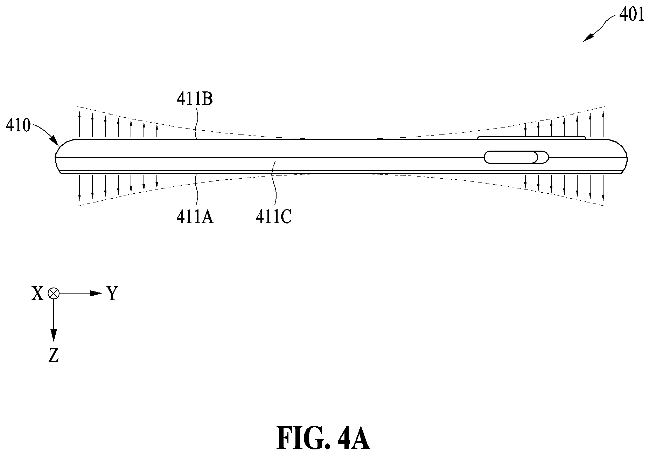

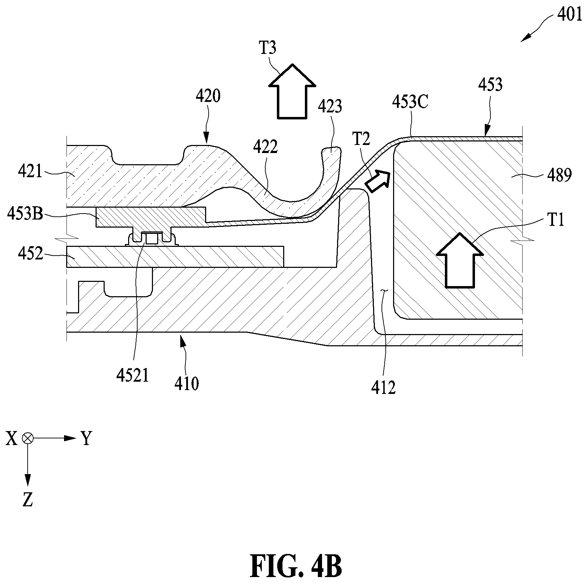

FIG. 4A is a side view of an electronic device according to an embodiment. FIG. 4B is a schematic cross-sectional view of a shock absorber according to an embodiment.

Referring to FIGS. 4A and 4B, due to an external disturbance which may occur to an electronic device 401 (e.g., the electronic device 301 in FIGS. 3A to 3F), a deformation (e.g., a bending moment in a +X direction) of a first plate 411A (e.g., the first plate 311A) and/or a deformation (e.g., a bending moment in a -X direction) of a second plate 411B (e.g., the second plate 311B in FIGS. 3A to 3F) may occur with respect to a third plate 411C (e.g., the third plate 311C in FIGS. 3A to 3F), and a battery 489 (e.g., the battery 389 in FIGS. 3A to 3F) received in a receiving portion 412 of a housing 410 (e.g., the housing 310 in FIGS. 3A to 3F) may start to move in a direction T1 separating from the first plate 411A.

When the battery 489 starts moving in the direction T1, an extension portion 453C (e.g., the extension portion 353C in FIGS. 3A to 3F) of an FPCB 453 (e.g., the FPCB 353 in FIGS. 3A to 3F) facing the battery 489 may be pulled in a direction T2 receding from a connector 453B (e.g., the second connector 353B in FIGS. 3A to 3F) connected to a PCB 452 (e.g., the second PCB 352 in FIGS. 3A to 3F). The connector 453B may then be coupled to a connector 4521 (e.g., the connector 3521 in FIGS. 3A to 3F) on the PCB 452.

When the FPCB 453 is pulled, a support portion 423 (e.g., the support portions 323-1 and 323-2 in FIGS. 3A to 3F) may support the extension portion 453C, and a deformable portion 422 may be elastically deformed against a cover 421A (e.g., the covers 321A-1 and 321A-2 in FIGS. 3A to 3F) to move in a direction T3 receding from the extension portion 453C.

As described above, a shock absorber 420 (e.g., the shock absorbers 320-1 and 320-2 in FIGS. 3A to 3F) may perform a buffering or cushioning operation to distribute stress concentrated on the FPCB 453 throughout, thereby reducing damage to or breakage of the connector 453B.

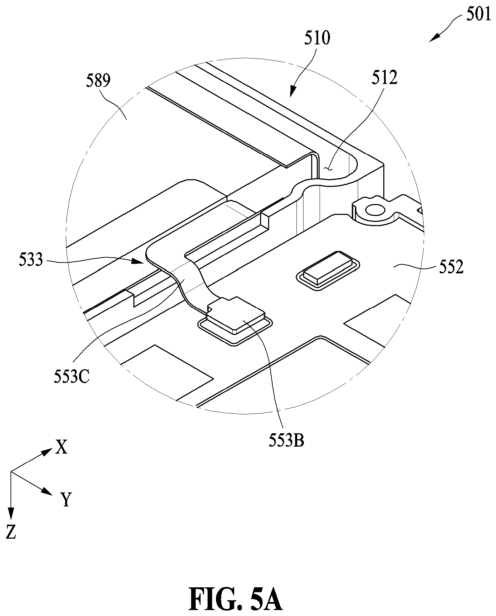

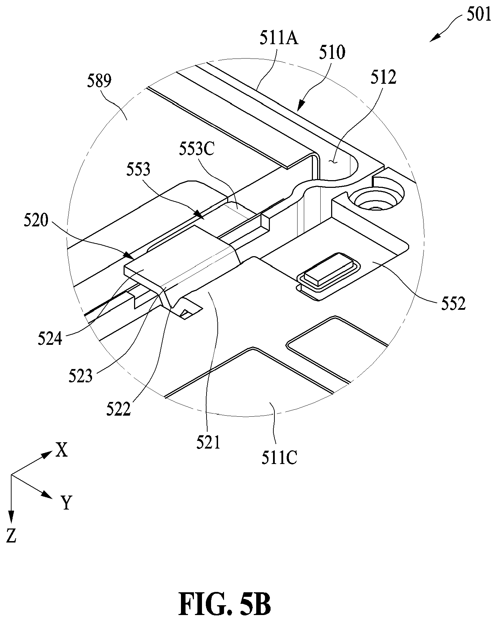

FIG. 5A is a perspective view of an internal structure of an electronic device without a shock absorber according to an embodiment. FIG. 5B is a perspective view of an internal structure of an electronic device with a shock absorber applied according to an embodiment.

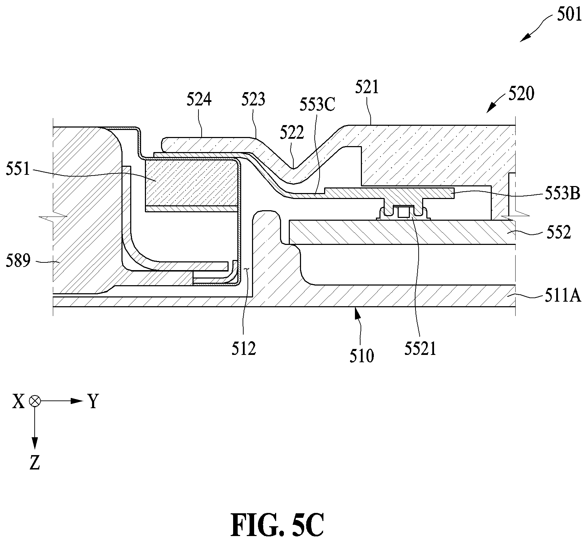

FIG. 5C is a schematic cross-sectional view of an electronic device with a shock absorber applied according to an embodiment.

Referring to FIGS. 5A to 5C, an electronic device 501 (e.g., the electronic device 301 in FIGS. 3A to 3F) may include a housing 510 (e.g., the housing 310 in FIGS. 3A to 3F). The housing 510 may include a first plate 511A (e.g., the first plate 311A in FIGS. 3A to 3F). The housing 510 may include a second plate (not shown) (e.g., the second plate 311B in FIGS. 3A to 3F). The housing 510 may include a third plate 511C (e.g., the third plate 311C in FIGS. 3A to 3F). The housing 510 may include a receiving portion 512 (e.g., the receiving portion 312 in FIGS. 3A to 3F).

In an embodiment, the electronic device 501 may include a battery 589 (e.g., the battery 389 in FIGS. 3A to 3F) at least partially received in the receiving portion 512.

In an embodiment, the electronic device 501 may include a first PCB 551 (e.g., the first PCB 351 in FIGS. 3A to 3F) connected to the battery 589. The electronic device 501 may include a second PCB 552 (e.g., the second PCB 352 in FIGS. 3A to 3F) including at least one electronic component (e.g., the power management module 188 in FIG. 1). The electronic device 501 may include an FPCB 553 (e.g., the FPCB 353 in FIGS. 3A to 3F) connecting the first PCB 551 and the second PCB 552 to each other.

In an embodiment, the FPCB 553 may include a connector 553B (e.g., the second connector 353B in FIGS. 3A to 3F) connected to the second PCB 552. The FPCB 553 may include an extension portion 553C (e.g., the extension portion 353C in FIGS. 3A to 3F) extending from the connector 553B. At least a portion of the extension portion 553C may be disposed on the battery 589. The connector 553B may be connected to a connector 5521 (e.g., the connector 3521 in FIGS. 3A to 3F) of the PCB 552.

In an embodiment, on an end of the extension portion 553C opposite to an end on which the connector 553B is disposed, there may be no connector (e.g., the first connector 353A in FIGS. 3A to 3F). The end of the extension portion 553C on which no connector is positioned may be integrally formed with the first PCB 551. The FPCB 553 may also include an additional connector (e.g., the first connector 353A in FIGS. 3A to 3F) connected to the first PCB 551.

In an embodiment, the electronic device 501 may include a shock absorber 520 (e.g., the shock absorbers 320-1 and 320-2 in FIGS. 3A to 3F) configured to buffer at least a portion of the FPCB 553. The shock absorber 520 may include a cover 521 (e.g., the covers 321-1 and 321-2 in FIGS. 3A to 3F) configured to cover the second connector 553B. The shock absorber 520 may include a deformable portion 522 (e.g., the deformable portions 322-1 and 322-2 in FIGS. 3A to 3F) configured to be deformed at least partially elastically against the cover 521. The shock absorber 520 may include a first support portion 523 (e.g., the support portions 323-1 and 323-2 in FIGS. 3A to 3F) configured to support the extension portion 553C. The shock absorber 520 may include a second support portion 524 configured to support at least a portion of the first PCB 551. The second support portion 524 may be connected to the first support portion 523, and may be positioned on the first PCB 551 while overlapping at least a portion of the extension portion 553C. The height of the second support portion 524 may be substantially the same as or less than the height of one side (e.g., a top surface) of the battery 589.

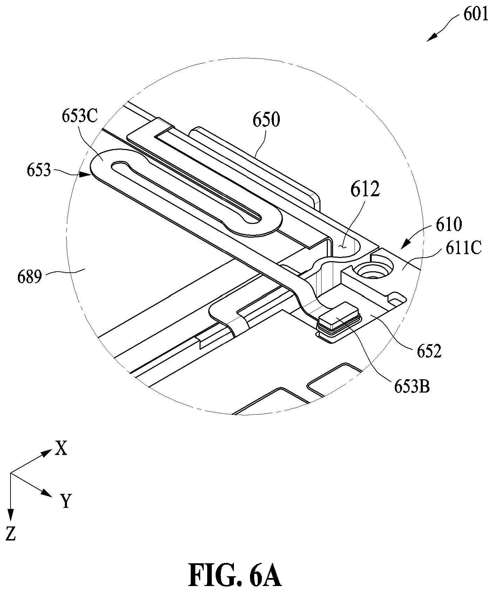

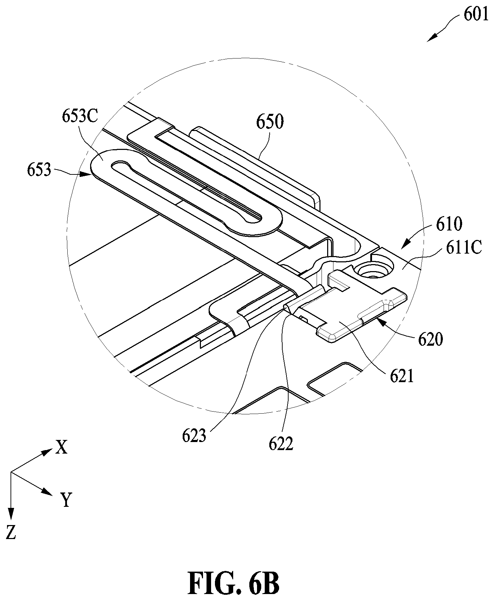

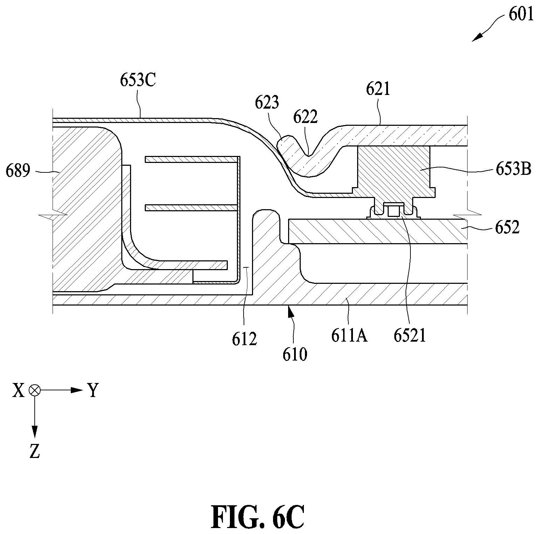

FIG. 6A is a perspective view of an internal structure of an electronic device without a shock absorber according to an embodiment. FIG. 6B is a perspective view of an internal structure of an electronic device with a shock absorber applied according to an embodiment. FIG. 6C is a schematic cross-sectional view of an electronic device with a shock absorber applied according to an embodiment.

Referring to FIGS. 6A to 6C, an electronic device 601 (e.g., the electronic device 301 in FIGS. 3A to 3F) may include a housing 610 (e.g., the housing 310 in FIGS. 3A to 3F). The housing 610 may include a first plate 611A (e.g., the first plate 311A in FIGS. 3A to 3F). The housing 610 may include a second plate (not shown) (e.g., the second plate 311B in FIGS. 3A to 3F). The housing 610 may include a third plate 611C (e.g., the third plate 311C in FIGS. 3A to 3F). The housing 610 may include a receiving portion 612 (e.g., the receiving portion 312 in FIGS. 3A to 3F). The electronic device 601 may include a battery 689 (e.g., the battery 389 in FIGS. 3A to 3F) at least partially received in the receiving portion 612.

In an embodiment, the electronic device 601 may include an input module 650 (e.g., the input module 250 in FIGS. 2A to 2C) positioned on one side (e.g., the third surface 210c in FIGS. 2A to 2C or a side surface) of the housing 610. The input module 650 may include a key input device configured to perform volume, power, and/or other functions. The key input device may include, for example, at least one key cap and a PCB (e.g., the first PCB 351 in FIGS. 3A to 3F) configured to recognize an operation of the at least one key cap.

In an embodiment, the electronic device 601 may include a first PCB (not shown) (e.g., the first PCB 351 in FIGS. 3A to 3F) connected to the input module 650. The electronic device 601 may include a second PCB 652 (e.g., the second PCB 352 in FIGS. 3A to 3F) including at least one electronic component (e.g., the processor 120 in FIG. 1). The electronic device 601 may include an FPCB 653 (e.g., the FPCB 353 in FIGS. 3A to 3F) connecting the first PCB and the second PCB 652.

In an embodiment, the FPCB 653 may include a connector 653B (e.g., the second connector 353B in FIGS. 3A to 3F) connected to the second PCB 652. The FPCB 653 may include an extension portion 653C (e.g., the extension portion 353C in FIGS. 3A to 3F) extending from the connector 653B. The connector 653B may be coupled to a connector 6521 (e.g., the connector 3521 in FIGS. 3A to 3F) on the PCB 652. The extension portion 653C may be implemented at least partially in a meander pattern. At least a portion of the extension portion 653C may be disposed on the battery 689.

In an embodiment, on an end of the extension portion 653C opposite an end on which the connector 653B is positioned, there may be no connector (e.g., the first connector 353A in FIGS. 3A to 3F) positioned. The end of the extension portion 653C on which no connector is positioned may be integrally formed with the first PCB (not shown). The FPCB 653 may include an additional connector (e.g., the first connector 353A in FIGS. 3A to 3F) connected to the first PCB.

In an embodiment, the electronic device 601 may include a shock absorber 620 (e.g., the shock absorbers 320-1 and 320-2 in FIGS. 3A to 3F) configured to buffer at least a portion of the FPCB 653. The shock absorber 620 may include a cover 621 (e.g., the covers 321-1 and 321-2 in FIGS. 3A to 3F) configured to cover the second connector 653B. The shock absorber 620 may include a deformable portion 622 (e.g., the deformable portions 322-1 and 322-2 in FIGS. 3A to 3F) configured to be deformed at least partially elastically against the cover 621. The shock absorber 620 may include a support portion 623 (e.g., the support portions 323-1 and 323-2 in FIGS. 3A to 3F) configured to support the extension portion 653C.

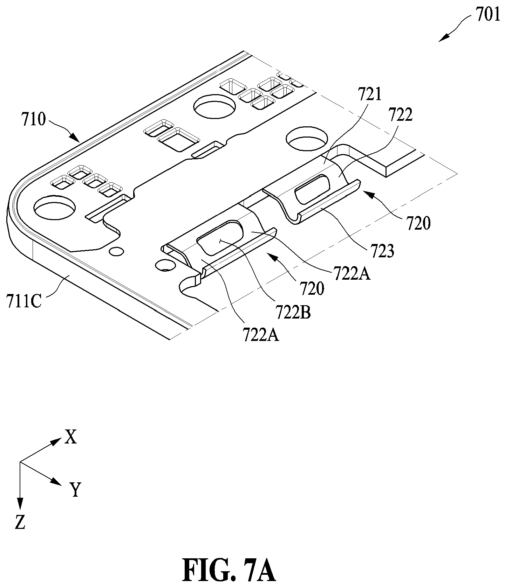

FIG. 7A is a perspective view of an electronic device including a shock absorber according to an embodiment.

Referring to FIG. 7A, an electronic device 701 (e.g., the electronic device 301 in FIGS. 3A to 3F) may include a housing 710 (e.g., the housing 310 in FIGS. 3A to 3F). The housing 710 may include a plate 711C (e.g., the third plate 311C in FIGS. 3A to 3F). The electronic device 701 may include at least one (e.g., two) shock absorber 720 (e.g., the shock absorbers 320-1 and 320-2 in FIGS. 3A to 3F) connected to the plate 711C. The shock absorber 720 may include a cover 721 (e.g., the covers 321-1 and 321-2 in FIGS. 3A to 3F). The shock absorber 720 may include a deformable portion 722 (e.g., the deformable portions 322-1 and 322-2 in FIGS. 3A to 3F). The shock absorber 720 may include a support portion 723 (e.g., the support portions 323-1 and 323-2 in FIGS. 3A to 3F). The deformable portion 722 may include a plurality of ribs 722A (e.g., the ribs 322A-1 and 322A-2 in FIGS. 3A to 3F). The deformable portion 722 may include an opening 722B (e.g., the openings 322B-1 and 322B-2 in FIGS. 3A to 3F).

In an embodiment, at least a portion of the shock absorber 720 may be connected, bonded, or coupled to the plate 711C through co-injection. For example, at least a portion of the cover 721 may be co-injected with the plate 711C, while a remaining portion of the cover 721, the deformable portion 722, and the support portion 723 may be injected separately from the plate 711C.

In an embodiment, at least a portion of the shock absorber 720 which is injected separately from the plate 711C may be formed of a different material from a material of the plate 711C. The elasticity of the material of the portion of the shock absorber 720 which is injected separately from the plate 711C may be greater than the elasticity of the material of the plate 711C. For example, the remaining portion of the cover 721, the deformable portion 722, and the support portion 723 may be formed of a metallic material (e.g., stainless steel (STS)).

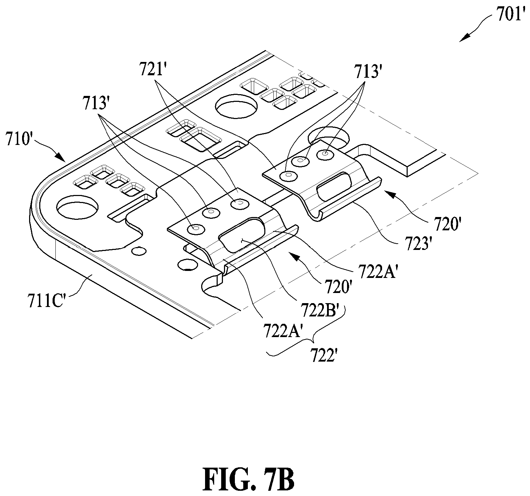

FIG. 7B is a perspective view of an electronic device including a shock absorber according to an embodiment.

Referring to FIG. 7B, an electronic device 701' (e.g., the electronic device 301 in FIGS. 3A to 3F) may include a housing 710' (e.g., the housing 310 in FIGS. 3A to 3F). The housing 710' may include a plate 711C' (e.g., the third plate 311C in FIGS. 3A to 3F). The electronic device 701' may include at least one (e.g., two) shock absorber 720' (e.g., the shock absorbers 320-1 and 320-2 in FIGS. 3A to 3F) connected to the plate 711C'. The shock absorber 720' may include a cover 721' (e.g., the covers 321-1 and 321-2 in FIGS. 3A to 3F). The shock absorber 720' may include a deformable portion 722' (e.g., the deformable portions 322-1 and 322-2 in FIGS. 3A to 3F). The shock absorber 720' may include a support portion 723' (e.g., the support portions 323-1 and 323-2 in FIGS. 3A to 3F). The deformable portion 722' may include a plurality of ribs 722A' (e.g., the ribs 322A-1 and 322A-2 in FIGS. 3A to 3F). The deformable portion 722' may include an opening 722B' (e.g., the openings 322B-1 and 322B-2 in FIGS. 3A to 3F).

In an embodiment, at least a portion of the shock absorber 720' may be connected, bonded, or coupled to the plate 711C' through co-injection. For example, the cover 721', the deformable portion 722', and the support portion 723' may be injected separately from the plate 711C'.

In an embodiment, at least a portion of the shock absorber 720' which is injected separately from the plate 711C' may be formed of a different material from a material of the plate 711C'. The elasticity of the material of the portion of the shock absorber 720' which is injected separately from the plate 711C' may be greater than the elasticity of the material of the plate 711C'. For example, the cover 721', the deformable portion 722', and the support portion 723' may be formed of a metallic material (e.g., stainless steel (STS)).

In an embodiment, the cover 721' may be bonded (e.g., fused) to the plate 711C' by at least one (e.g., three) bonding portion 713'. For example, the bonding portion 713' may include a weld.

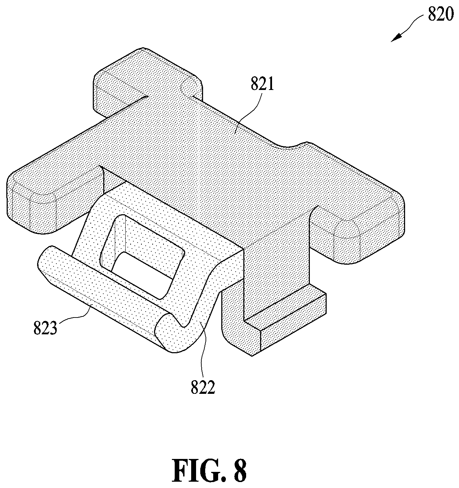

FIG. 8 is a perspective view of a shock absorber according to an embodiment.

Referring to FIG. 8, a shock absorber 820 (e.g., the shock absorbers 320-1 and 320-2 in FIGS. 3A to 3F) may include a cover 821 (e.g., the covers 321-1 and 321-2 in FIGS. 3A to 3F). The shock absorber 820 may include a deformable portion 822 (e.g., the deformable portions 322-1 and 322-2 in FIGS. 3A to 3F). The shock absorber 820 may include a support portion 823 (e.g., the support portions 323-1 and 323-2 in FIGS. 3A to 3F).

In an embodiment, the shock absorber 820 may have a plurality of parts implemented by multi-injection. For example, the cover 821 may be injected separately from the deformable portion 822 and the support portion 823.

In an embodiment, the cover 821 may be formed of a first material, and the deformable portion 822 and the support portion 823 may be formed of a second material which is different from the first material. The first material may be a material with a relatively low elasticity, while the second material may be a material with a relatively high elasticity. For example, the first material may include a plastic and/or metallic material, while the second material may include urethane and/or rubber.

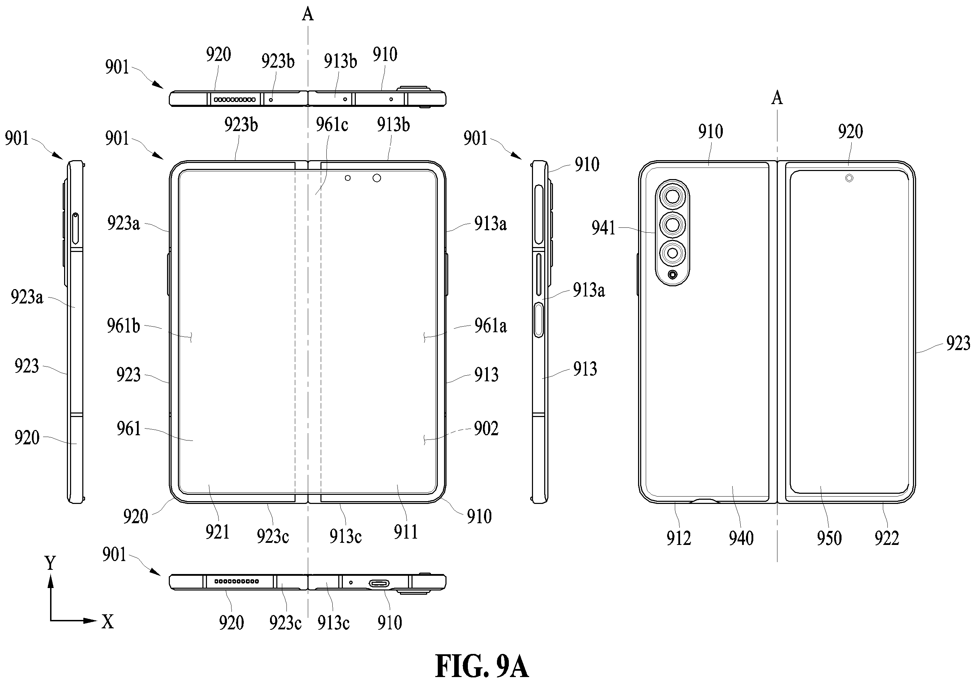

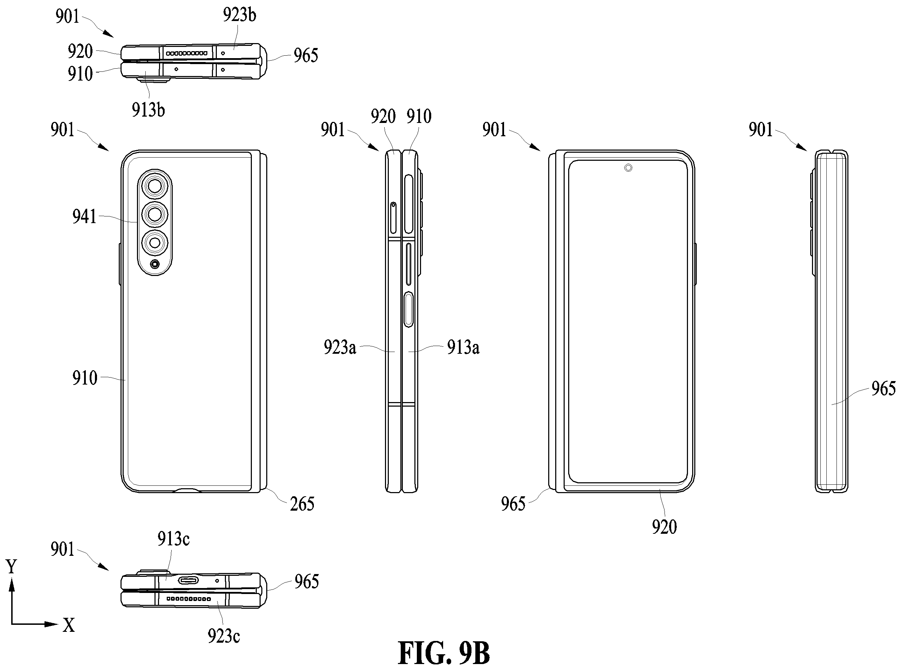

FIG. 9A is a diagram illustrating an electronic device in an unfolded state according to an embodiment. FIG. 9B is a diagram illustrating an electronic device in a folded state according to an embodiment.

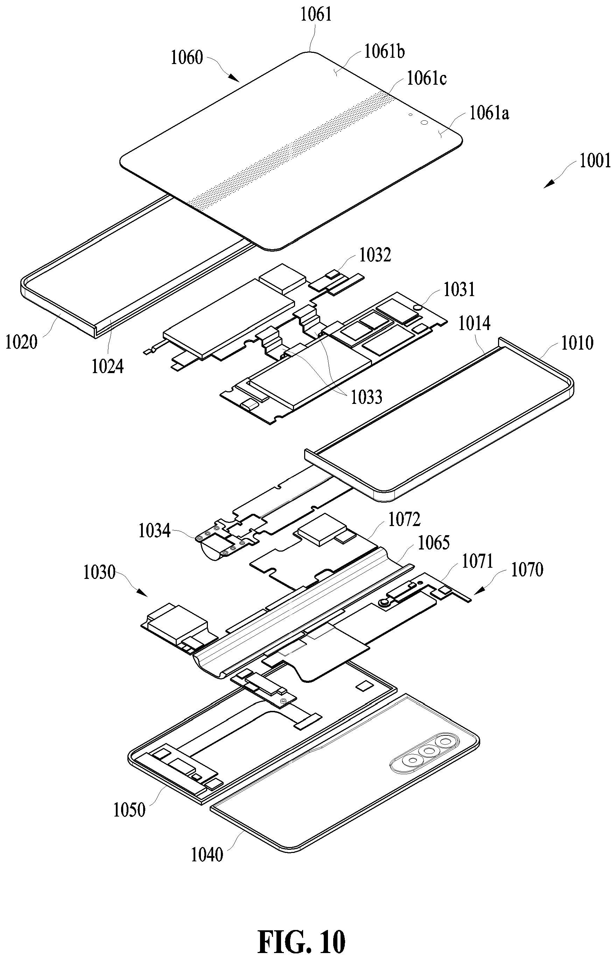

Referring to FIGS. 9A and 9B, an electronic device 901 may include a pair of housings 910 and 920 rotatably or movably coupled to each other through a hinge structure (e.g., a hinge structure 1034 in FIG. 10) so as to be folded against each other, a hinge cover 965 covering a foldable portion of the pair of housings 910 and 920, and a display 961 (e.g., a flexible display or foldable display) disposed in a space formed by the pair of housings 910 and 920. A surface on which the display 961 is disposed may be defined herein as the front of the electronic device 901, and a surface opposite the front may be defined herein as the back or rear of the electronic device 901. In addition, a surface surrounding a space between the front and the back may be defined herein as the side of the electronic device 901.

In an embodiment, the pair of housings 910 and 920 may include a first housing 910, a second housing 920, a first rear cover 940, and a second rear cover 950. The pair of housings 910 and 920 of the electronic device 901 is not limited to the shape or the combination and/or coupling of parts or components shown in FIGS. 9A and 9B but may be implemented in other shapes or other combinations and/or couplings of parts or components.

In an embodiment, the first housing 910 and the second housing 920 may disposed on both sides with respect to a folding axis A and may be arranged substantially symmetrically with respect to the folding axis A. In an embodiment, an angle or distance formed between the first housing 910 and the second housing 920 may depend on whether the electronic device 901 is in an unfolded state, a folded state, or an intermediate state. In an embodiment, the first housing 910 and the second housing 920 may have substantially mutually symmetrical shapes.

**In** an embodiment, the first housing 910 may be connected to the hinge structure (e.g., the hinge structure 1034 in FIG. 10) when the electronic device 901 is in the unfolded state. The first housing 910 may include a first surface 911 disposed to face the front of the electronic device 901. The first housing 910 may include a second surface 912 facing in an opposite direction of the first surface 911. The first housing 910 may include a first side portion 913 surrounding at least a portion of a space between the first surface 911 and the second surface 912. The first side portion 913 may include a first side surface 913a disposed substantially parallel to the folding axis A. The first side portion 913 may include a second side surface 913b extending from one end of the first side surface 913a in a direction substantially perpendicular to the folding axis A. The first side portion 913 may include a third side surface 913c extending from the other end of the first side surface 913a in a direction substantially perpendicular to the folding axis A and substantially parallel to the second side surface 913b.

In an embodiment, the second housing 920 may be connected to the hinge structure (e.g., the hinge structure 1034 in FIG. 10) when the electronic device 901 is in the unfolded state. The second housing 920 may include a third surface 921 disposed to face the front of the electronic device 901. The second housing 920 may include a fourth surface 922 facing in an opposite direction of the third surface 921. The second housing 920 may include a second side portion 923 surrounding at least a portion of a space between the third surface 921 and the fourth surface 922. The second side portion 923 may include a fourth side surface 923a disposed substantially parallel to the folding axis A. The second side portion 923 may include a fifth side surface 923b extending from one end of the fourth side surface 923a in a direction substantially perpendicular to the folding axis A. The second side portion 923 may include a sixth side surface 923c extending from the other end of the fourth side surface 923a in a direction substantially perpendicular to the folding axis A and substantially parallel to the fifth side surface 923b. The first surface 911 and the third surface 921 may face each other when the electronic device 901 is in the folded state.

In an embodiment, the electronic device 901 may include at least one sound output module (e.g., the sound output module 155 in FIG. 1) disposed on the fifth side surface 923b and/or the sixth side surface 923c of the second housing 920.

In an embodiment, the electronic device 901 may include a recess-shaped receiving portion 902 which receives therein the display 961 through a structural coupling of the first housing 910 and the second housing 920. The receiving portion 902 may have substantially the same size as the display 961.

In an embodiment, at least a portion of the first housing 910 and the second housing 920 may be formed of a metallic material or a non-metallic material having the rigidity suitable for supporting the display 961.

In an embodiment, the electronic device 901 may include at least one component for performing various functions, which is disposed to be exposed to the front of the electronic device 901. The component may include, for example, at least one of a front camera module, a receiver, a proximity sensor, an illumination sensor, an iris recognition sensor, an ultrasonic sensor, or an indicator.

In an embodiment, the first rear cover 940 may be disposed on the second surface 912 of the first housing 910 and may have substantially rectangular edges. At least a portion of the edges of the first rear cover 940 may be surrounded by the first housing 910. The second rear cover 950 may be disposed on the fourth surface 922 of the second housing 920 and may have substantially rectangular edges. At least a portion of the edges of the second rear cover 950 may be surrounded by the second housing 920.

In an embodiment, the first rear cover 940 and the second rear cover 950 may have substantially symmetrical shapes with respect to the folding axis A. The first rear cover 940 and the second rear cover 950 may have different shapes. The first housing 910 and the first rear cover 940 may be integrally formed, and the second housing 920 and the second rear cover 950 may be integrally formed.

In an embodiment, the first housing 910, the second housing 920, the first rear cover 940, and the second rear cover 950 may be coupled to each other to provide a space in which various components (e.g., a PCB, the antenna module 197 in FIG. 1, the sensor module 176 in FIG. 1, or the battery 189 in FIG. 1) of the electronic device 901 are disposed. At least one component may be visually exposed on the rear of the electronic device 901. For example, at least one component may be visually exposed through a first rear area 941 of the first rear cover 940. In this case, the component may include a proximity sensor, a rear camera module, and/or a flash.

In an embodiment, the display 961 may be disposed in the receiving portion 902 formed by the pair of housings 910 and 920. For example, the display 961 may be disposed to occupy substantially most of the front of the electronic device 901. The front of the electronic device 901 may include an area in which the display 961 is disposed, and a partial area (e.g., an edge area) of the first housing 910 and a partial area (e.g., an edge area) of the second housing 920 which are adjacent to the display 961. The rear of the electronic device 901 may include the first rear cover 940, a partial area (e.g., an edge area) of the first housing 910 adjacent to the first rear cover 940, the second rear cover 950, and a partial area (e.g., an edge area) of the second housing 920 adj acent to the second rear cover 950. In an embodiment, the display 961 may be a display in which at least a partial area is deformable into a flat or curved surface.

In an embodiment, the display 961 may include a flexible area 961c, a first area 961a on a first side (e.g., a right side) with respect to the flexible area 961c, and a second area 961b on a second side (e.g., a left side) with respect to the flexible area 961c. The first area 961a may be disposed on the first surface 911 of the first housing 910, and the second area 961b may be disposed on the third surface 921 of the second housing 920. However, such areal division of the display 961 is provided only as an example, and the display 961 may be divided into a plurality of areas depending on the structure or function of the display 961. For example, as shown in FIG. 9A, the display 961 may be divided into areas by the flexible area 961c or the folding axis A extending parallel to a Y axis, but the display 961 may be divided into areas by another flexible area (e.g., a flexible area extending parallel to an X axis) or another folding axis (e.g., a folding axis parallel to the X-axis).

The areal division of the display 961 described above may only be a physical division by the pair of housings 910 and 920 and the hinge structure (e.g., the hinge structure 1034 in FIG. 10), and the display 961 may display substantially one screen through the pair of housings 910 and 920 and the hinge structure (e.g., the hinge structure 1034 in FIG. 10).

In an embodiment, the first area 961a and the second area 961b may have substantially symmetrical shapes with respect to the flexible area 961c.

In an embodiment, the hinge cover 965 may be disposed between the first housing 910 and the second housing 920 and configured to cover the hinge structure (e.g., the hinge structure 1034 in FIG. 10). The hinge cover 965 may be hidden or exposed to the outside by at least a portion of the first housing 910 and the second housing 920 depending on an operating state of the electronic device 901. For example, as shown in FIG. 9A, when the electronic device 901 is in the unfolded state, the hinge cover 965 may be hidden by the first housing 910 and the second housing 920 not to be exposed to the outside. As shown in FIG. 9B, when the electronic device 901 is in the folded state, the hinge cover 965 may be exposed to the outside between the first housing 910 and the second housing 920. In addition, when the electronic device 901 is in the intermediate state in which the first housing 910 and the second housing 920 form an angle with each other, at least a portion of the hinge cover 965 may be exposed to the outside between the first housing 910 and the second housing 920. In this case, an area of the hinge cover 965 exposed to the outside may be smaller than an area of the hinge cover 965 exposed to the outside when the electronic device 901 is in the folded state. In an embodiment, the hinge cover 965 may have a curved surface.

Regarding the operations of the electronic device 901, in an embodiment, when the electronic device 901 is in the unfolded state (e.g., a state of the electronic device 901 shown in FIG. 9A), the first housing 910 and the second housing 920 may form a first angle (e.g., about 180 degrees) with each other, and the first area 961a and the second area 961b of the display 961 may be oriented substantially in the same direction. The flexible area 961c of the display 961 may be substantially on the same plane as the first area 961a and the second area 961b. When the electronic device 901 is in the unfolded state, as the first housing 910 rotates or moves at a second angle (e.g., about 360 degrees) with respect to the second housing 920, the first housing 910 and the second housing 920 may be folded in opposite directions such which the second surface 912 and the fourth surface 922 face each other.

In addition, when the electronic device 901 is in the folded state (e.g., a state of the electronic device 901 shown in FIG. 9B), the first housing 910 and the second housing 920 may face each other. The first housing 910 and the second housing 920 may form an angle of about 0 degrees to about 10 degrees, and the first area 961a and the second area 961b of the display 961 may face each other. At least a portion of the flexible area 961c of the display 961 may be deformed into a curved surface.

In addition, when the electronic device 901 is in the intermediate state, the first housing 910 and the second housing 920 may form a specific angle with each other. The angle (e.g., a third angle, about 90 degrees) formed between the first area 961a and the second area 961b of the display 961 may be greater than an angle formed when the electronic device 901 is in the folded state and may be smaller than an angle formed when the electronic device 901 is in the unfolded state. At least a portion of the flexible area 961c of the display 961 may be deformed into a curved surface. In this case, a curvature of the curved surface of the flexible area 961c may be smaller than a curvature of the curved surface of the flexible area 961c formed when the electronic device 901 is in the folded state.

FIG. 10 is an exploded perspective view of an electronic device according to an embodiment.

Referring to FIG. 10, an electronic device 1001 may include a display module 1060 (e.g., the display module 160 in FIG. 1). The electronic device 1001 may include a hinge assembly 1030. The electronic device 1001 may include a substrate 1070. The electronic device 1001 may include a first housing 1010 (e.g., the first housing 910 in FIGS. 9A and 9B) and a second housing 1020 (e.g., the second housing 920 in FIGS. 9A and 9B). The electronic device 1001 may include a first rear cover 1040 (e.g., the first rear cover 940 in FIGS. 9A and 9B) and a second rear cover 1050 (e.g., the second rear cover 950 in FIGS. 9A and 9B).

In an embodiment, the display module 1060 may include a display 1061 (e.g., the display 961 in FIGS. 9A and 9B) and at least one layer or plate on which the display 1061 is seated. The plate may be disposed between the display 1061 and the hinge assembly 1030. The display 1061 may be disposed on at least a portion of one side (e.g., a top surface) of the plate. The plate may be formed in a shape corresponding to the display 1061.

In an embodiment, the hinge assembly 1030 may include a first bracket 1031. The hinge assembly 1030 may include a second bracket 1032. The hinge assembly 1030 may include a hinge structure 1034 disposed between the first bracket 1031 and the second bracket 1032. The hinge assembly 1030 may include a hinge cover 1065 which covers the hinge structure 1034 when the hinge structure 1034 is viewed from the outside. The hinge assembly 1030 may include a PCB 1033 crossing the first bracket 1031 and the second bracket 1032. The PCB 1033 may include an FPCB.

In an embodiment, the hinge assembly 1030 may be disposed between the plate and the substrate 1070. For example, the first bracket 1031 may be disposed between a first area 1061a of the display 1061 and a first substrate 1071. The second bracket 1032 may be disposed between a second area 1061b of the display 1061 and a second substrate 1072.

In an embodiment, inside the hinge assembly 1030, the PCB 1033 and at least a portion of the hinge structure 1034 may be disposed. The PCB 1033 may be disposed in a direction (e.g., an X-axis direction) crossing the first bracket 1031 and the second bracket 1032. The PCB 1033 may be disposed in a direction (e.g., the X-axis direction) perpendicular to a folding axis (e.g., a Y axis or the folding axis A in FIG. 9A) of a flexible area 1061c of the electronic device 1001.

In an embodiment, the substrate 1070 may include the first substrate 1071 disposed on the first bracket 1031 side and the second substrate 1072 disposed on the second bracket 1032 side. The first substrate 1071 and the second substrate 1072 may be disposed inside a space formed by the hinge assembly 1030, the first housing 1010, the second housing 1020, the first rear cover 1040, and the second rear cover 1050. On the first substrate 1071 and the second substrate 1072, components for implementing various functions of the electronic device 1001 may be disposed.

In an embodiment, the first housing 1010 and the second housing 1020 may be assembled with each other to be coupled to both sides of the hinge assembly 1030, with the display module 1060 coupled to the hinge assembly 1030. The first housing 1010 and the second housing 1020 may be slidably coupled to the hinge assembly 1030 on both sides of the hinge assembly 1030.

In an embodiment, the first housing 1010 may include a first rotatable support surface 1014. The second housing 1020 may include a second rotatable support surface 1024 corresponding to the first rotatable support surface 1014. The first rotatable support surface 1014 and the second rotatable support surface 1024 may include a curved surface corresponding to a curved surface included in the hinge cover 1065.

In an embodiment, when the electronic device 1001 is in the unfolded state (e.g., the electronic device 901 in FIG. 9A), the first rotatable support surface 1014 and the second rotatable support surface 1024 may cover the hinge cover 1065 such that the hinge cover 1065 is not exposed or minimally exposed to the rear of the electronic device 1001. On the other hand, when the electronic device 1001 is in the folded state (e.g., the electronic device 901 in FIG. 9B), the first rotatable support surface 1014 and the second rotatable support surface 1024 may rotate along the curved surface included in the hinge cover 1065 such that the hinge cover 1065 is maximally exposed to the rear of the electronic device 1001.

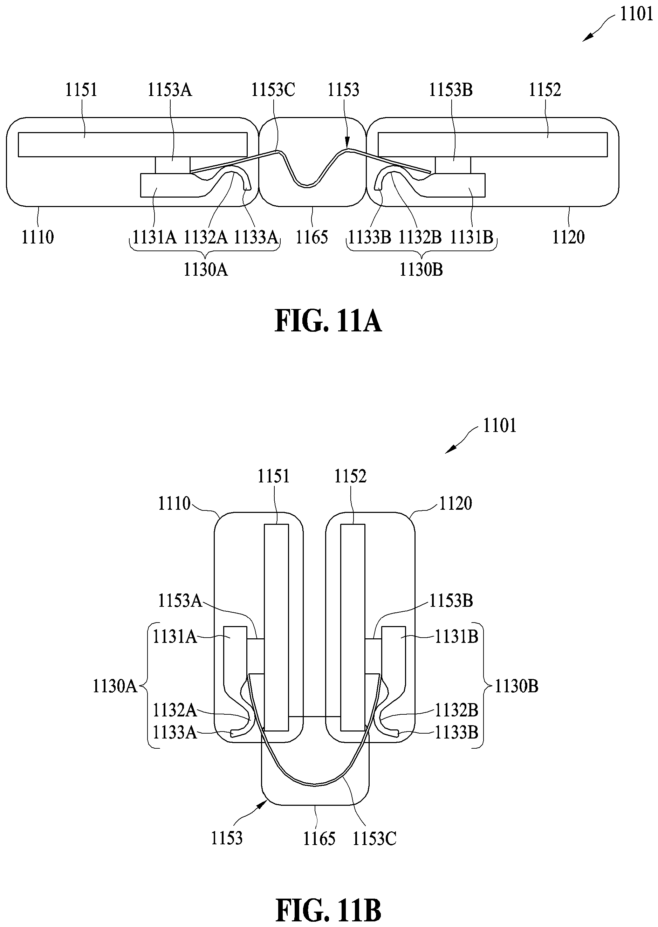

FIG. 11A is a diagram schematically illustrating an electronic device in an unfolded state according to an embodiment. FIG. 11B is a diagram schematically illustrating an electronic device in a folded state according to an embodiment.

Referring to FIGS. 11A and 11B, an electronic device 1101 (e.g., the electronic device 901 in FIGS. 9A and 9B and/or the electronic device 1001 in FIG. 10) may include a first housing 1110 (e.g., the first housing 910 in FIGS. 9A and 9B and/or the first housing 1010 in FIG. 10). The electronic device 1101 may include a second housing 1120 (e.g., the second housing 920 in FIGS. 9A and 9B and/or the second housing 1020 in FIG. 10). The electronic device 1101 may include a hinge cover 1165 (e.g., the hinge cover 965 in FIGS. 9A and 9B and/or the hinge cover 1065 in FIG. 10). The electronic device 1101 may include a first PCB 1151 (e.g., the first substrate 1071 in FIG. 10) disposed in the first housing 1110. The electronic device 1101 may include a second PCB 1152 (e.g., the second substrate 1072 in FIG. 10) disposed in the second housing 1120. The electronic device 1101 may include an FPCB 1153 (e.g., the PCB 1033 in FIG. 10) connecting the first PCB 1151 and the second PCB 1152 to each other. The FPCB 1153 may include a first connector 1153A connected to the first PCB 1151. The FPCB 1153 may include a second connector 1153B connected to the second PCB 1152. The FPCB 1153 may include an extension portion 1153C extending between the first connector 1153A and the second connector 1153B.

In an embodiment, the electronic device 1101 may include a first shock absorber 1130A. The first shock absorber 1130A may include a first cover 1131A (e.g., the covers 321-1 and 321-2 in FIGS. 3A to 3F) configured to cover the first connector 1153A. The first shock absorber 1130A may include a first deformable portion 1132A (e.g., the deformable portions 322-1 and 322-2 in FIGS. 3A to 3F) connected to the first cover 1131A and configured to be deformed elastically with respect to the first cover 1131A. The first shock absorber 1130A may include a first support portion 1133A (e.g., the support portions 323-1 and 323-2 in FIGS. 3A to 3F) connected to the first deformable portion 1132A and configured to support at least a portion of the extension portion 1153C positioned in the first housing 1110.

In an embodiment, the electronic device 1101 may include a second shock absorber 1130B. The second shock absorber 1130B may include a second cover 1131B (e.g., the covers 321-1 and 321-2 in FIGS. 3A to 3F) configured to cover the second connector 1153B. The second shock absorber 1130B may include a second deformable portion 1132B (e.g., the deformable portions 322-1 and 322-2 in FIGS. 3A to 3F) connected to the second cover 1131B and configured to be deformed elastically with respect to the second cover 1131B. The second shock absorber 1130B may include a second support portion 1133B (e.g., the support portions 323-1 and 323-2 in FIGS. 3A to 3F) connected to the second deformable portion 1132B and configured to support at least a portion of the extension portion 1153C positioned in the second housing 1120.

In an embodiment, in an unfolded state (e.g., a state shown in FIG. 11A) of the electronic device 1101, the first shock absorber 1130A and/or the second shock absorber 1130B may be pressing the extension portion 1153C. The extension portion 1153C may have an increased length in a folded state (e.g., a state shown in FIG. 11B) of the electronic device 1101 than in the unfolded state of the electronic device 1101. In this state, the first shock absorber 1130A and/or the second shock absorber 1130B may be lifted in a direction receding from the extension portion 1153C to distribute stress concentrated on the extension portion 1153C, and thus the length of the extension portion 1153C may be secured as the state of the electronic device 1101 changes.

When an external force is applied to an electronic device and the electronic device is deformed accordingly, stress may be concentrated in at least a portion of an FPCB between connectors, which may result in breakage of the FPCB. An aspect of the present disclosure may provide a shock absorber configured to distribute stress which may be concentrated on an FPCB, and an electronic device including the shock absorber.

According to an embodiment, stress that may be concentrated on an FPCB may be distributed. According to an embodiment, the FPCB having an increased free length may be disposed in an electronic device. According to an embodiment, breakage and/or disconnection of connectors to the FPCB may be reduced. The effects of a shock absorber and an electronic device including the shock absorber according to an embodiment are not limited to those described above, and other effects not described above may be apparent to those having ordinary skill in the art from the description provided herein.

## Claims

1. An electronic device (301), comprising:
a first printed circuit board (351);
a second printed circuit board (352);
a battery (389) disposed between the first printed circuit board (351) and the second printed circuit board (352);
a flexible printed circuit board (353) connected to each of the first printed circuit board (351) and the second printed circuit board (352) and extending between the first printed circuit board (351) and the second printed circuit board (352); and
a shock absorber (320-1, 320-2) configured to buffer the flexible printed circuit board (353),
wherein the shock absorber (320-1, 320-2) comprises:
a deformable portion (322-1, 322-2) configured to be at least partially elastically deformed, wherein the deformable portion (322-1, 322-2) comprises a rib (322A-1, 322A-2) formed along an extending direction of the flexible printed circuit board (353), and an opening (322B-1, 322B-2) surrounded by the rib (322A-1, 322A-2); and
a support portion (323-1, 323-2) configured to support at least a portion of the flexible printed circuit board (353), wherein the support portion (323-1, 323-2) has a curved surface facing the flexible printed circuit board (353), wherein the curved surface is at least partially in contact with the flexible printed circuit board (353),
wherein the battery (389) faces the flexible printed circuit board (353), and an end of the support portion (323) is positioned substantially flush with or lower than a surface of the battery (389) facing the flexible printed circuit board (353).

2. The electronic device of claim 1, wherein the shock absorber (320-1, 320-2) comprises a cover (321A-1, 321A-2) configured to at least partially cover a connector (353B) of the flexible printed circuit board (353) connected to the first printed circuit board (351) or the second printed circuit board (352).

3. The electronic device of any one of claims 1 to 2, wherein the shock absorber (320-1, 320-2) further comprises a deformable portion (322-1, 322-2) configured to be at least partially elastically deformed, and the thickness of the cover (321A-1, 321A-2) is substantially equal to or greater than the thickness of the deformable portion (322-1, 322-2).

4. The electronic device of any one of claims 1 to 3, wherein the shock absorber (320-1) comprises:
a deformable portion (322-1) configured to be at least partially elastically deformed;
and
at least one recess (321B-1) formed in an area connected to the deformable portion (322-1).

5. The electronic device (501) of any one of claims 1 to 4, further comprising:
a battery (589) in which the first printed circuit board (551) is disposed,
wherein the shock absorber (520) comprises:
a deformable portion (522) configured to be at least partially elastically deformed;
a first support portion (523) connected to the deformable portion (522) and configured to support the flexible printed circuit board (353); and
a second support portion (524) configured to support the first printed circuit board (551).

6. The electronic device (601) of any one of claims 1 to 5, further comprising:
a key input device (650) in which the first printed circuit board (351) is disposed,
wherein the shock absorber (320) comprises:
a deformable portion (622) configured to be at least partially elastically deformed; and
a support portion (623) connected to the deformable portion (622) and configured to support the flexible printed circuit board (353).

7. The electronic device (701) of any one of claims 1 to 6, wherein the shock absorber (720) is formed at least partially of a metallic material.

8. The electronic device (701') of any one of claims 1 to 7, further comprising:
a housing (310, 710') configured to receive therein the first printed circuit board (351), the second printed circuit board (352), and the flexible printed circuit board (353), wherein the shock absorber (720') is welded to the housing (710').

9. The electronic device of any one of claims 1 to 8, wherein the shock absorber (820) comprises:
a cover (321A-1, 321A-2, 821) configured to at least partially cover the connector (353B) of the flexible printed circuit board (353) connected to the first printed circuit board (351) or the second printed circuit board (352) and having a first elasticity; and
a deformable portion (322-1, 322-2, 822) connected to the cover (321A-1, 321A-2, 821), configured to be at least partially elastically deformed, and having a second elasticity greater than the first elasticity.

10. The electronic device (1101) of any one of claims 1 to 9, comprising:
a first housing (1110) comprising the first printed circuit board (1151); and
a second housing (1120) comprising the second printed circuit board (1152), wherein the second housing (1120) is oriented with respect to the first housing (1110) between a folded state in which it forms a first angle with the first housing (1110) and an unfolded state in which it forms a second angle different from the first angle with the first housing (1110),
wherein the shock absorber comprises:
a first shock absorber (1130A) disposed in the first housing (1110) and configured to buffer the flexible printed circuit board (1153); and
a second shock absorber (1130B) disposed in the second housing (1120) and configured to buffer the flexible printed circuit board (1153).

11. The electronic device of any one of claims 1 to 10, wherein the first shock absorber (1130A) and the second shock absorber (1130B) comprise, respectively, deformable portions (1132A, 1132B) configured to be at least partially elastically deformed.

12. The electronic device of any one of claims 1 to 11, wherein the first shock absorber (1130A) and the second shock absorber (1130B) further comprise, respectively, support portions (1133A, 1133B) connected to the deformable portions (1132A, 1132B) and configured to support the flexible printed circuit board (1153), and/or
the first shock absorber (1130A) and the second shock absorber (1130B) further comprise covers (1131A, 1131B), respectively, wherein the covers (1131A, 1131B) are connected to the deformable portions (1132A, 1132B), and configured to at least partially cover a first connector (1153A) of the flexible printed circuit board (1153) connected to the first printed circuit board (1151) and configured to at least partially cover a second connector (1153B) of the flexible printed circuit board (1153) connected to the second printed circuit board (1152), respectively.

## Patentansprüche

1. Elektronische Vorrichtung (301), umfassend:
eine erste Leiterplatte (351);
eine zweite Leiterplatte (352);
eine Batterie (389), die zwischen der ersten Leiterplatte (351) und der zweiten Leiterplatte (352) angeordnet ist;
eine flexible Leiterplatte (353), die jeweils mit der ersten Leiterplatte (351) und der zweiten Leiterplatte (352) verbunden ist und sich zwischen der ersten Leiterplatte (351) und der zweiten Leiterplatte (352) erstreckt; und
eine Stoßsicherung (320-1, 320-2), die dazu konfiguriert ist, die flexible Leiterplatte (353) zu puffern,
wobei die Stoßsicherung (320-1, 320-2) Folgendes umfasst:
einen verformbaren Abschnitt (322-1, 322-2), der dazu konfiguriert ist, zumindest teilweise elastisch verformt zu werden, wobei der verformbare Abschnitt (322-1, 322-2) eine Rippe (322A-1, 322A-2), die entlang einer Erstreckungsrichtung der flexiblen Leiterplatte (353) ausgebildet ist, und eine Öffnung (322B-1, 322B-2), die von der Rippe (322A-1, 322A-2) umgeben ist, umfasst; und
einen Stützabschnitt (323-1, 323-2), der dazu konfiguriert ist, zumindest einen Abschnitt der flexiblen Leiterplatte (353) zu stützen, wobei der Stützabschnitt (323-1, 323-2) eine gekrümmte Oberfläche aufweist, die der flexiblen Leiterplatte (353) zugewandt ist, wobei die gekrümmte Oberfläche zumindest teilweise in Kontakt mit der flexiblen Leiterplatte (353) ist,
wobei die Batterie (389) der flexiblen Leiterplatte (353) zugewandt ist und ein Ende des Stützabschnitts (323) im Wesentlichen bündig mit einer oder niedriger als eine Oberfläche der Batterie (389) positioniert ist, die der flexiblen Leiterplatte (353) zugewandt ist.

2. Elektronische Vorrichtung nach Anspruch 1, wobei die Stoßsicherung (320-1, 320-2) eine Abdeckung (321A-1, 321A-2) umfasst, die dazu konfiguriert ist, einen Verbinder (353B) der flexiblen Leiterplatte (353), die mit der ersten Leiterplatte (351) oder der zweiten Leiterplatte (352) verbunden ist, zumindest teilweise abzudecken.

3. Elektronische Vorrichtung nach einem der Ansprüche 1 bis 2, wobei die Stoßsicherung (320-1, 320-2) ferner einen verformbaren Abschnitt (322-1, 322-2) umfasst, der dazu konfiguriert ist, zumindest teilweise elastisch verformt zu werden, und die Dicke der Abdeckung (321 A-1, 321A-2) im Wesentlichen gleich oder größer als die Dicke des verformbaren Abschnitts (322-1, 322-2) ist.

4. Elektronische Vorrichtung nach einem der Ansprüche 1 bis 3, wobei die Stoßsicherung (320-1) Folgendes umfasst:
einen verformbaren Abschnitt (322-1), der dazu konfiguriert ist, zumindest teilweise elastisch verformt zu werden; und
zumindest eine Aussparung (321B-1), die in einem Bereich ausgebildet ist, der mit dem verformbaren Abschnitt (322-1) verbunden ist.

5. Elektronische Vorrichtung (501) nach einem der Ansprüche 1 bis 4, ferner umfassend:
eine Batterie (589), in der die erste Leiterplatte (551) angeordnet ist,
wobei die Stoßsicherung (520) Folgendes umfasst:
einen verformbaren Abschnitt (522), der dazu konfiguriert ist, zumindest teilweise elastisch verformt zu werden;
einen ersten Stützabschnitt (523), der mit dem verformbaren Abschnitt (522) verbunden ist und dazu konfiguriert ist, die flexible Leiterplatte (353) zu stützen; und
einen zweiten Stützabschnitt (524), der dazu konfiguriert ist, die erste Leiterplatte (551) zu stützen.

6. Elektronische Vorrichtung (601) nach einem der Ansprüche 1 bis 5, ferner umfassend:
eine Tasteneingabevorrichtung (650), in der die erste Leiterplatte (351) angeordnet ist, wobei die Stoßsicherung (320) Folgendes umfasst:
einen verformbaren Abschnitt (622), der dazu konfiguriert ist, zumindest teilweise elastisch verformt zu werden; und
einen ersten Stützabschnitt (623), der mit dem verformbaren Abschnitt (622) verbunden ist und dazu konfiguriert ist, die flexible Leiterplatte (353) zu stützen.

7. Elektronische Vorrichtung (701) nach einem der Ansprüche 1 bis 6, wobei die Stoßsicherung (720) zumindest teilweise aus einem metallischen Material gebildet ist.

8. Elektronische Vorrichtung (701') nach einem der Ansprüche 1 bis 7, ferner umfassend:
ein Gehäuse (310, 710'), das dazu konfiguriert ist, die erste Leiterplatte (351), die zweite Leiterplatte (352) und die flexible Leiterplatte (353) darin aufzunehmen, wobei die Stoßsicherung (720') an das Gehäuse (710') geschweißt ist.

9. Elektronische Vorrichtung nach einem der Ansprüche 1 bis 8, wobei die Stoßsicherung (820) Folgendes umfasst:
eine Abdeckung (321A-1, 321A-2, 821), die dazu konfiguriert ist, den Verbinder (353B) der flexiblen Leiterplatte (353), die mit der ersten Leiterplatte (351) oder der zweiten Leiterplatte (352) verbunden ist und eine erste Elastizität aufweist, zumindest teilweise abzudecken; und
einen verformbaren Abschnitt (322-1, 322-2, 822), der mit der Abdeckung (321A-1, 321A-2, 821) verbunden ist und dazu konfiguriert ist, zumindest teilweise elastisch verformt zu werden, und eine zweite Elastizität aufweist, die größer als die erste Elastizität ist.

10. Elektronische Vorrichtung (1101) nach einem der Ansprüche 1 bis 9, umfassend:
ein erstes Gehäuse (1110), das die erste Leiterplatte (1151) umfasst; und
ein zweites Gehäuse (1120), das die zweite Leiterplatte (1152) umfasst, wobei das zweite Gehäuse (1120) in Bezug auf das erste Gehäuse (1110) zwischen einem gefalteten Zustand, in dem es einen ersten Winkel mit dem ersten Gehäuse (1110) bildet, und einem aufgeklappten Zustand, in dem es einen zweiten Winkel, der sich von dem ersten Winkel unterscheidet, mit dem ersten Gehäuse (1110) bildet, ausgerichtet ist,
wobei die Stoßsicherung Folgendes umfasst:
eine erste Stoßsicherung (1130A), die in dem ersten Gehäuse (1110) angeordnet ist und dazu konfiguriert ist, die flexible Leiterplatte (1153) zu puffern; und
eine zweite Stoßsicherung (1130B), die in dem zweiten Gehäuse (1120) angeordnet ist und dazu konfiguriert ist, die flexible Leiterplatte (1153) zu puffern.

11. Elektronische Vorrichtung nach einem der Ansprüche 1 bis 10, wobei die erste Stoßsicherung (1130A) und die zweite Stoßsicherung (1130B) jeweils verformbare Abschnitte (1132A, 1132B) umfassen, die dazu konfiguriert sind, zumindest teilweise elastisch verformt zu werden.

12. Elektronische Vorrichtung nach einem der Ansprüche 1 bis 11, wobei die erste Stoßsicherung (1130A) und die zweite Stoßsicherung (1130B) ferner jeweils Stützabschnitte (1133A, 1133B) umfassen, die mit den verformbaren Abschnitten (1132A, 1132B) verbunden sind und dazu konfiguriert sind, die flexible Leiterplatte (1153) zu stützen, und/oder
die erste Stoßsicherung (1130A) und die zweite Stoßsicherung (1130B) ferner jeweils Abdeckungen (1131A, 1131B) umfassen, wobei die Abdeckungen (1131A, 1131B) mit den verformbaren Abschnitten (1132A, 1132B) verbunden sind und dazu konfiguriert sind, einen ersten Verbinder (1153A) der flexiblen Leiterplatte (1153), die mit der ersten Leiterplatte (1151) verbunden ist, zumindest teilweise abzudecken, bzw. dazu konfiguriert sind, einen zweiten Verbinder (1153B) der flexiblen Leiterplatte (1153), die mit der zweiten Leiterplatte (1152) verbunden ist, zumindest teilweise zu abzudecken.

## Revendications

1. Dispositif électronique (301) comprenant :
une première carte de circuit imprimé (351) ;
une seconde carte de circuit imprimé (352) ;
une batterie (389) disposée entre la première carte de circuit imprimé (351) et la seconde carte de circuit imprimé (352) ;
une carte de circuit imprimé souple (353) connectée à chacune de la première carte de circuit imprimé (351) et de la seconde carte de circuit imprimé (352) et s'étendant entre la première carte de circuit imprimé (351) et la seconde carte de circuit imprimé (352) ; et
un amortisseur (320-1, 320-2) conçu pour faire tampon pour la carte de circuit imprimé souple (353),
dans lequel l'amortisseur (320-1, 320-2) comprend :
une partie déformable (322-1, 322-2) conçue pour être au moins partiellement déformée élastiquement, dans lequel la partie déformable (322-1, 322-2) comprend une nervure (322A-1, 322A-2) formée le long d'une direction d'extension de la carte de circuit imprimé souple (353), et une ouverture (322B-1, 322B-2) entourée par la nervure (322A-1, 322A-2) ; et
une partie de support (323-1, 323-2) conçue pour supporter au moins une partie de la carte de circuit imprimé souple (353), dans lequel la partie de support (323-1, 323-2) présente une surface incurvée faisant face à la carte de circuit imprimé souple (353), dans lequel la surface incurvée est au moins partiellement en contact avec la carte de circuit imprimé souple (353),
dans lequel la batterie (389) fait face à la carte de circuit imprimé souple (353), et une extrémité de la partie de support (323) est positionnée sensiblement au même niveau ou plus bas qu'une surface de la batterie (389) faisant face à la carte de circuit imprimé souple (353).

2. Dispositif électronique de la revendication 1, dans lequel l'amortisseur (320-1, 320-2) comprend un couvercle (321A-1, 321A-2) conçu pour couvrir au moins partiellement un connecteur (353B) de la carte de circuit imprimé souple (353) connecté à la première carte de circuit imprimé (351) ou à la seconde carte de circuit imprimé (352).

3. Dispositif électronique de l'une quelconque des revendications 1 à 2, dans lequel l'amortisseur (320-1, 320-2) comprend en outre une partie déformable (322-1, 322-2) conçue pour être au moins partiellement déformée élastiquement, et l'épaisseur du couvercle (321A-1, 321A-2) est sensiblement égale ou supérieure à l'épaisseur de la partie déformable (322-1, 322-2).

4. Dispositif électronique de l'une quelconque des revendications 1 à 3, dans lequel l'amortisseur (320-1) comprend :
une partie déformable (322-1) conçue pour être au moins partiellement déformée élastiquement ; et
au moins un évidement (321B-1) formé dans une zone connectée à la partie déformable (322-1).

5. Dispositif électronique (501) de l'une quelconque des revendications 1 à 4, comprenant en outre :
une batterie (589) où est disposée la première carte de circuit imprimé (551),
dans lequel l'amortisseur (520) comprend :
une partie déformable (522) conçue pour être au moins partiellement déformée élastiquement ;
une première partie de support (523) connectée à la partie déformable (522) et conçue pour supporter la carte de circuit imprimé souple (353) ; et
une seconde partie de support (524) configurée pour supporter la première carte de circuit imprimé (551).

6. Dispositif électronique (601) de l'une quelconque des revendications 1 à 5, comprenant en outre :
un dispositif d'entrée de clé (650) où la première carte de circuit imprimé (351) est disposée,
dans lequel l'amortisseur (320) comprend :
une partie déformable (622) conçue pour être au moins partiellement déformée élastiquement ; et
une partie de support (623) connectée à la partie déformable (622) et conçue pour supporter la carte de circuit imprimé souple (353).

7. Dispositif électronique (701) de l'une quelconque des revendications 1 à 6, dans lequel l'amortisseur (720) est formé au moins partiellement d'un matériau métallique.

8. Dispositif électronique (701') de l'une quelconque des revendications 1 à 7, comprenant en outre :
un boîtier (310, 710') conçu pour recevoir, dans celui-ci, la première carte de circuit imprimé (351), la seconde carte de circuit imprimé (352) et la carte de circuit imprimé souple (353), dans lequel l'amortisseur (720') est soudé au boîtier (710').

9. Dispositif électronique de l'une quelconque des revendications 1 à 8, dans lequel l'amortisseur (820) comprend :
un couvercle (321A-1, 321A-2, 821) conçu pour couvrir au moins partiellement le connecteur (353B) de la carte de circuit imprimé souple (353) connecté à la première carte de circuit imprimé (351) ou à la seconde carte de circuit imprimé (352) et présentant une première élasticité ; et
une partie déformable (322-1, 322-2, 822) connectée au couvercle (321A-1, 321A-2, 821), conçue pour être au moins partiellement déformée élastiquement, et présentant une seconde élasticité supérieure à la première élasticité.

10. Dispositif électronique (1101) de l'une quelconque des revendications 1 à 9, comprenant :
un premier boîtier (1110) comprenant la première carte de circuit imprimé (1151) ; et
un second boîtier (1120) comprenant la seconde carte de circuit imprimé (1152), dans lequel le second boîtier (1120) est orienté par rapport au premier boîtier (1110) entre un état plié où il forme un premier angle avec le premier boîtier (1110) et un état déplié où il forme un second angle différent du premier angle avec le premier boîtier (1110),
dans lequel l'amortisseur comprend :
un premier amortisseur (1130A) disposé dans le premier boîtier (1110) et conçu pour faire tampon pour la carte de circuit imprimé souple (1153) ; et
un second amortisseur (1130B) disposé dans le second boîtier (1120) et conçu pour faire tampon pour la carte de circuit imprimé souple (1153).

11. Dispositif électronique de l'une quelconque des revendications 1 à 10, dans lequel le premier amortisseur (1130A) et le second amortisseur (1130B) comprennent, respectivement, des parties déformables (1132A, 1132B) conçues pour être au moins partiellement déformées élastiquement.

12. Dispositif électronique de l'une quelconque des revendications 1 à 11, dans lequel le premier amortisseur (1130A) et le second amortisseur (1130B) comprennent en outre, respectivement, des parties de support (1133A, 1133B) connectées aux parties déformables (1132A, 1132B) et conçues pour supporter la carte de circuit imprimé souple (1153), et/ou
le premier amortisseur (1130A) et le second amortisseur (1130B) comprennent en outre des couvercles (1131A, 1131B), respectivement, dans lesquels les couvercles (1131A, 1131B) sont connectés aux parties déformables (1132A, 1132B), et conçus pour couvrir au moins partiellement un premier connecteur (1153A) de la carte de circuit imprimé souple (1153) connecté à la première carte de circuit imprimé (1151) et conçus pour couvrir au moins partiellement un second connecteur (1153B) de la carte de circuit imprimé souple (1153) connecté à la seconde carte de circuit imprimé (1152), respectivement.
